# EUROPEAN PATENT APPLICATION

(11) **EP 2 559 720 A1**
(43) Date of publication of application: **20.02.2013**
(21) Application number: 11768907.5
(22) Date of filing: 14.04.2011
(51) Int. Cl.: C08G 73/00, C08G 16/02, H01L 29/786, H01L 51/05, H01L 51/30, H01L 51/40

(54) **CROSSLINKED COMPOSITION**

(30) Priority: 16.04.2010 JP 2010095527
(71) Applicant: Daicel Corporation, Osaka-shi, Osaka 530-0001 (JP)
(72) Inventor: FUKUI Kazuhisa, Hyogo 671-1283 (JP); FUNAKI Yoshinori, Hyogo 671-1283 (JP); NOBUTANI Mami, Himeji-shi Hyogo 671-1283 (JP)
(74) Representative: Grünecker, Kinkeldey, Stockmair & Schwanhäusser
(86) International application number: PCT/JP2011/059239
(87) International publication number: WO 2011/129386

(57) **Abstract**

To provide a composition (e.g., a coating composition) useful for forming an organic semiconductor having excellent conductivity, solvent resistance, heat resistance, durability, and other properties, and an organic semiconductor formed with the composition.

The composition comprises an aromatic polycarbonyl compound having a carbonyl group as a reactive site, and at least one aromatic reactive component selected from an aromatic polyamine having an amino group as a reactive site, and an aromatic heterocyclic compound having a plurality of unmodified α-carbon positions, as reactive sites, each of which is adjacent to a hetero atom of a heterocycl thereof. When the aromatic reactive component is an aromatic heterocyclic compound, the aromatic polycarbonyl compound is an aromatic polyaldehyde compound. Use of the composition in which at least one component of the aromatic polycarbonyl compound and the aromatic reactive component has not less than 3 reactive sites per molecule forms an organic semiconductor having a three-dimensional crosslinked structure.

## Description

### TECHNICAL FIELD

The present invention relates to a crosslinkable composition for providing excellent conductivity, solvent resistance, heat resistance, durability, and other properties [in particular, a composition (e.g., a coating composition) useful for forming an organic semiconductor] and an organic semiconductor or the like formed with the composition.

### BACKGROUND ART

As organic semiconductors, a low-molecular-weight type and a high-molecular-weight type are known. For example, as a low-molecular-weight-type organic semiconductor component, Japanese Patent Application Laid-Open Publication No. 2004-346082 (JP-2004-346082A, Patent Document 1) discloses a tertiary amine compound represented by the following formula (1), and other compounds, and discloses that the tertiary amine compound having at least one group having an electron donor chemical structure and an electron acceptor chemical structure in a molecule thereof can improve the cohesive force and control the molecular orientation. 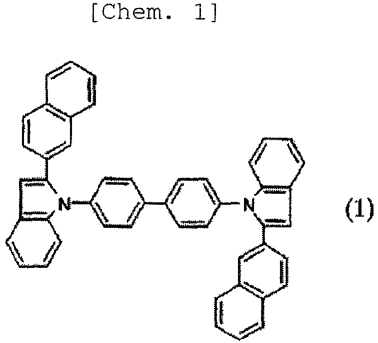 Japanese Patent Application Laid-Open Publication No. 2008-283104 (JP-2008-283104A, Patent Document 2) discloses an organic semiconductor material represented by the following formula (2) and discloses that, by depositing a solution of the compound represented by the formula (2) on a substrate and removing the solvent, a projection formed by Ar₁ and Ar₂ is fitted into a recess formed by Ar₁-A₁-(A₃)ₙ-A₂-Ar₂ due to an stack effect of π-conjugated molecules, thus a highly crystalline layer is obtained. 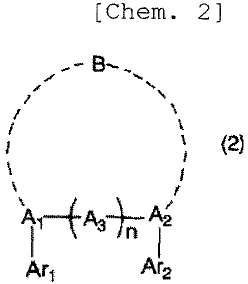 In the formula, B represents a condensed polycyclic compound; Ar₁ and Ar₂ each represent an aromatic hydrocarbon ring or an aromatic heterocycle; A₁, A₂, and A₃ each represent a constituent atom of the condensed polycyclic compound represented by B; and n is an integer of 3 to 5.
These low molecular weight compounds, however, require high-level molecular design. Specifically, in the compound represented by the formula (1) , a molecular design for intermolecular overlapping of π-electrons is needed. Whereas, in the compound represented by the formula (2), a molecular design for arranging intermolecular recesses and projections without leaving space between adjucent molecules is needed. Moreover, although the intermolecular electron transfer (hopping) is required because of a low molecular weight thereof, sometimes the hopping does not occur depending on the molecular vibration influenced by heat or voltage, and the decrease of conductivity cannot be avoided. Further, since such a low molecular weight compound is inferior in solvent resistance, a uniform laminated structure cannot be formed by further applying a coating composition containing an organic solvent on a layer containing the low molecular weight compound.

Whereas, as a high-molecular-weight-type organic semiconductor component, a high molecular weight compound having a main chain formed by a conjugated system [e.g., a poly(p-phenylene)] is known. Such a high molecular weight compound has an excellent conductivity, since the electron can be transferred along the main chain without using hopping. The high molecular weight compound, however, has a rigid molecule structure and is insoluble in a solvent. Thus it is difficult to form the compound into a layer (or a film) by a simple method (such as coating). Moreover, in order to improve the solubility, as an example, introduction of a steric hindrance alkyl chain into a molecule of a compound inhibits the crystallization of the compound to make the compound soluble in a solvent. The compound, however, tends to increase the internal resistance.

It is also known to polymerize monomer components on a substrate for forming a layer of a high molecular weight compound. For example, Japanese Patent Application Laid-Open Publication No. 8-113622 (JP-8-113622A, Patent Document 3) discloses a polyazomethine having a repeating unit represented by the following formula (3):

[Chem. 3] (̵X-N=CH-Y-CH=N)̵ (3)

wherein X represents an aromatic hydrocarbon group or a group derived from a heterocyclic compound, and Y represents a group having an aromatic tertiary amine skeleton.
This document discloses that, when the polyazomethine is used as a thin-film electroluminescent device material, the polyazomethine is obtained by allowing a diamino compound represented by the following formula (4a) to react with a dialdehyde compound represented by the following formula (4b):

[Chem. 4] X(̵NH₂)₂ (4a) Y(̵CHO )₂ (4b)

wherein X and Y have the same meanings as defined above.
According to this document, however, since an organic semiconductor is obtained by vapor deposition polymerization of the dialdehyde compound and the diamino compound, the ratio of both components cannot accurately be controlled, and thus it is difficult to form a uniform layer. Further, since the polyazomethine is a linear polymer, the resulting organic semiconductor is insufficient in conductivity, solvent resistance, and durability.

Japanese Patent Application Laid-Open Publication No. 2008-091066 (JP-2008-091066A, Patent Document 4) discloses an organic semiconductor film (or layer) obtained by dissolving a functional resin containing a crosslinking unit in a solvent, applying this solution to a substrate, heat-treating the resultant for removing the solvent and for crosslinking the crosslinking unit to form an insoluble functional resin. This document discloses, as the functional resin, a poly(9,9-dioctylfluorene) having both ends treated with phenylepoxide. In the crosslinking reaction, however, since the molecules are coupled through a dialkyl ether, the conductivity is insufficient as the whole molecule.

Japanese Patent Application Laid-Open Publication No. 63-125512 (JP-63-125512A, Patent Document 5) discloses that an electroactive polymer having a 5-membered aromatic heterocycle in a main chain thereof is obtained by allowing an aldehyde represented by the formula R₃CHO (wherein R₃ represents an aliphatic group, an aromatic group, or a heterocyclic group) to react with pyrrole, thiophene (including dithiophene, terthiophene, and the like), or furan in the presence of a protic acid catalyst. Japanese Patent Application Laid-Open Publication No. 7-228650 (JP-7-228650A, Patent Document 6) discloses a polymer for electroluminescent device, which is obtained by allowing a benzaldehyde to react with a heterocyclic compound (e.g., thiophene) in the presence of an acid catalyst to produce a polymer precursor and subjecting the polymer precursor to dehydrogenation reaction. EP1 505 095 A1 (Patent Document 7) discloses a polymer containing a pyrrole ring in a main chain thereof , which is obtained by allowing pyrrole to react with an aldehyde or a ketone in the presence of a Lewis acid or a strong acid.

These polymers disclosed in these documents, however, are linear polymers, each having a heterocycle in a main chain thereof. These polymers are therefore insufficient in conductivity, solvent resistance, and durability.

Meanwhile, nowadays, utilization of an organic semiconductor for solar cell is being attempted. The organic semiconductor, however, strongly binds an electron and an electron hole compared with an inorganic semiconductor, and has an extremely low photoelectric conversion efficiency. Although the combination of the organic semiconductor and the inorganic semiconductor is also suggested, a high photoelectric effect cannot be achieved yet due to a low conductivity of the organic semiconductor as described above.

### RELATED ART DOCUMENTS

### PATENT DOCUMENTS

Patent Document 1: JP-2004-346082A (Claims, Paragraph [0016], and Examples)
Patent Document 2: JP-2008-283104A (Claims, and Paragraphs [0030] to [0032])
Patent Document 3: JP-8-113622A (Claims and Paragraph [0042])
Patent Document 4: JP-2008-091066A (Claims, and Paragraph [0018])
Patent Document 5: JP-63-125512A (Claims)
Patent Document 6: JP-7-228650A (Claims and Paragraphs [0008] to [0014])
Patent Document 7: EP1 505 095 A1 (Claims)

### SUMMARY OF THE INVENTION

### PROBLEMS TO BE SOLVED BY THE INVENTION

It is therefore an object of the present invention to provide a crosslinkable composition (or a coating composition) useful for forming an organic semiconductor having a low resistance and a high conductivity (carrier mobility) in spite of a high-molecular-weight type thereof, an organic semiconductor formed with the composition, and a device comprising the organic semiconductor.

Another object of the present invention is to provide a composition (or an coating composition) useful for forming an organic semiconductor which has an excellent heat resistance and inhibits the change of film or layer quality (crystallization) and prevents shortening of the lifetime of a device even if an external energy (such as heat) is applied, an organic semiconductor formed with the composition, and a device comprising the organic semiconductor.

It is still another object of the present invention to provide a composition (or a coating composition) useful for forming an organic semiconductor which has an excellent solvent resistance, an organic semiconductor formed with the composition, and a device comprising the organic semiconductor.

It is a further object of the present invention to provide a composition (a coating composition) for an organic semiconductor, which is easily formed into a layer (or a film) by a simple method (such as coating), an organic semiconductor formed with the composition, and a device comprising the organic semiconductor.

It is a still further object of the present invention to provide a composition (or a coating composition) having a high stability and being useful for forming an organic semiconductor at a low temperature, an organic semiconductor formed with the composition, and a device comprising the organic semiconductor.

It is another object of the present invention to provide a composition (or a coating composition) for an organic semiconductor in which characteristics can easily be controllable by coordinating the species or amount of a polymerizable component (or a reactive component), an organic semiconductor formed with the composition, and a device comprising the organic semiconductor.

A still another object of the present invention is to provide a composition (or a coating composition) useful for forming an organic semiconductor which can form a pseudo or quasi band structure as a whole and easily form a hybrid (or composite) with an inorganic semiconductor, an organic semiconductor formed with the composition, and a device comprising the organic semiconductor.

### MEANS TO SOLVE THE PROBLEMS

The inventors of the present invention made intensive studies to achieve the above objects and finally found that, when an organic semiconductor is formed with a composition comprising an aromatic polycarbonyl compound and at least one an aromatic reactive component selected from the group consisting of an aromatic polyamine and an aromatic heterocyclic compound having a plurality of unmodified α-carbon positions each adjacent to a hetero atom of the heterocycle thereof, in which at least one of these components has not less than 3 reactive sites (3- or more-functional component), the organic semiconductor has a three-dimensional crosslinked structure, reduces the resistance in spite of a high-molecular-weight type thereof, and increases the carrier mobility to improve the conductivity. The present invention was accomplished based on the above findings.

That is, the composition of the present invention comprises an aromatic polycarbonyl compound having a carbonyl group as a reactive site and at least one aromatic reactive component selected from the group consisting of an aromatic polyamine having an amino group (a reactive group to the carbonyl group) as a reactive site, and an aromatic heterocyclic compound having a plurality of unmodified α-carbon positions (α-carbon positions which are not modifided (or substituted)), as reactive sites, each of which is adjacent to a hetero atom of the heterocycle. The composition is useful as a composition for forming an organic semiconductor. In the composition, when the aromatic reactive component is an aromatic heterocyclic compound, the aromatic polycarbonyl compound is an aromatic polyaldehyde compound, at least one component of the aromatic polycarbonyl compound and the aromatic reactive component has not less than 3 reactive sites in one molecule thereof.

The composition (particularly, the composition useful for forming an organic semiconductor) may be (1) a composition comprising the aromatic polycarbonyl compound and the aromatic polyamine, in which at least one component of the aromatic polycarbonyl compound and the aromatic polyamine has not less than 3 reactive sites per molecule, or (2) a composition comprising an aromatic polyaldehyde compound having formyl group as a reactive site and an aromatic heterocyclic compound having a plurality of unmodified α-carbon positions, as reactive sites (reactive sites to formyl group), which are adjacent to a hetero atom of a heterocycle thereof, wherein at least one component of the aromatic polyaldehyde compound and the aromatic heterocyclic compound has not less than 3 reactive sites per molecule.

Further, the composition may be (3) a composition comprising the combination of the above-mentioned (1) and (2), that is, the composition may comprise the aromatic polycarbonyl compound, the aromatic polyamine, the aromatic polyaldehyde compound and the aromatic heterocyclic compound, and at least one component among these components has not less than 3 reactive sites [formyl group (aldehyde group), amino group and/or unmodified α-carbon position] in one molecule thereof. In this composition, the aromatic polycarbonyl compound may comprise an aromatic polyaldehyde compound.

The aromatic polycarbonyl compoundmaybe a compound represented by the following formula (Ia) : 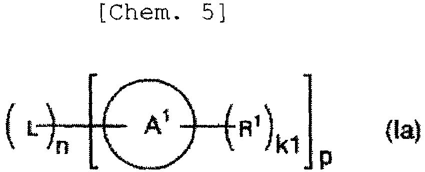 wherein L represents a linker; A¹ represents a ring having aromaticity (or an aromatic ring); R¹ represents a carbonyl-containing group; n is 0 or 1; k1 is an integer of not less than 1; and p is an integer of not less than 1; with the proviso that k1 x p is an integer of not less than 2.
In the formula (Ia), "k1 x p is an integer of not less than 2" means that the total number of R¹ contained in a molecule is not less than 2.

The compound represented by the formula (Ia) may be any one of the following compounds (a1) to (a4).

(a1) a compound, wherein the ring A¹ is a monocyclic or condensed bi- to hepta-cyclic aromatic hydrocarbon ring (e.g., a C₆₋₂₄arene ring such as benzene ring or naphthalene ring), or a condensed bi- to hepta-cyclic nitrogen-atom-containing aromatic heterocycle (e.g., carbazole ring); n is 0; k1 is 2 or 3; and p is 1;
(a2) a compound, wherein the ring A¹ is a monocyclic or condensed bi- to hepta-cyclic aromatic hydrocarbon ring (e.g. , a C₆₋₂₄arene ring such as benzene ring or naphthalene ring); n is 0; k1 is 1 or 2; and p is 2;
(a3) a compound, wherein the ring A¹ is a monocyclic or condensed bi- to heptacyclic aromatic hydrocarbon ring (e. g. , a C₆₋₂₄arene ring such as benzene ring or naphthalene ring);
   the linker L is nitrogen atom, oxygen atom, sulfur atom, vinylene group, a di- to tetra-valent aromatic carbocyclic (or hydrocarbon ring) or aromatic heterocyclic group [for example, a di- to tetra-valent group corresponding to an aromatic ring selected from an arene ring (e. g. , a C₆₋₂₄arene ring such as benzene ring or naphthalene ring) and a porphyrin ring; for example, an arylene group (such as phenylene group), an arene-triyl group (such as benzene-triyl group), and a porphyrin-tetrayl group];
   n is 1;
   k1 is 1 or 2; and
   p is 2 to 4; and
(a4) a compound, wherein the ring A¹ is a porphyrin or phthalocyanine ring; n is 0; k1 is 2 to 4; and p is 1.

The aromatic polyamine may be a compound represented by the following formula (IIa): 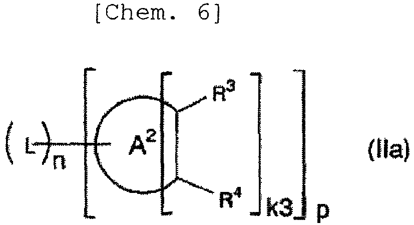 wherein A² represents a ring having aromaticity; R³ represents an amino group; R⁴ represents hydrogen atom, an amino group, a mercapto group, or hydroxyl group; k3 is an integer of not less than 1; L, n, and p have the same meanings as defined above; with the proviso that k3 x p is an integer of not less than 2.
In the formula (IIa), the case "when k3 is an integer of not less than 2" means that the ring A² has not less than two pairs of the groups R³ and R⁴, which are in the ortho-position. Moreover, the case "k3 x p is an integer of not less than 2" means that the total number of pairs of R³ and R⁴ contained in the molecule is not less than 2.

The compound represented by the formula (IIa) may be any one of the following compounds (b1) to (b4):

(b1) a compound, wherein the ring A² is a monocyclic or condensed bi- to hepta-cyclic aromatic hydrocarbon ring (such as benzene ring, naphthalene ring, fluorene ring, pyrene ring, anthraquinone ring, or coronene ring), or a condensed bi- to hepta-cyclic nitrogen-atom-containing aromatic heterocycle (such as carbazole ring or phenanthridine ring); n is 0; k3 is 2 or 3; and p is 1;
(b2) a compound, wherein the ring A² is a monocyclic or condensed bi- to hepta-cyclic aromatic hydrocarbon ring (e.g., a C₆₋₂₄arene ring such as benzene ring or naphthalene ring); n is 0; k3 is 1 or 2; and p is 2;
(b3) a compound, wherein the ring A² is a monocyclic or condensed bi- to hepta-cyclic aromatic hydrocarbon ring (e.g., a C₆₋₂₄arene ring such as benzene ring or naphthalene ring) ;
   the linker L is nitrogen atom, oxygen atom, sulfur atom, disulfide group, vinylene group, a di- to tetra-valent aromatic carbocyclic or heterocyclic group [e.g., a di-to tetra-valent group corresponding to at least one aromatic ring selected from the group consisting of an arene ring (e. g. , a C₆₋₂₄arene ring such as benzene ring or naphthalene ring), a heterocycle having oxygen atom and nitrogen atom, and a porphyrin ring; for example, an arylene group (such as phenylene group or 9,9-fluorene-diyl group), an arene-triyl group (such as benzene-triyl group), an oxazole-diyl group, an oxadiazole-diyl group, and a porphyrin-tetrayl group], a group which has an arylene group having an azo group at each terminal thereof, a group which has vinylene group having an azo group through an arylene group at each terminal thereof, or a group which has an arylarene-diyl group having an oxygen atom at each terminal thereof;
   n is 1;
   k3 is 1 or 2; and
   p is 2 to 4; and
(b4) a compound, wherein the ring A² is a porphyrin or phthalocyanine ring; n is 0; k3 is 2 to 4; and p is 1.

The composition may comprise an aromatic polyaldehyde compound having 2 to 4 formyl groups as reactive sites in one molecule thereof and an aromatic polyamine having 2 to 4amino groups as reactive sites (reactive groups to carbonyl group) in one molecule thereof, wherein at least one component of the aromatic polyaldehyde compound and the aromatic polyamine may have not less than 3 reactive sites.

The aromatic heterocyclic compound may comprise at least one member selected from the group consisting of a monocyclic compound, a condensed cyclic compound, and a ring-assembly compound. The aromatic heterocyclic compound may contain a 5- to 8-membered aromatic heterocycle having at least one hetero atom selected from the group consisting of oxygen atom, sulfur atom, nitrogen atom, selenium atom and tellurium atom as a hetero atom of the heterocycle thereof. Further, the aromatic heterocyclic compound may contain a 5-membered aromatic heterocycle having at least one hetero atom selected from the group consisting of sulfur atom, oxygen atom, and nitrogen atom as a hetero atom of the heterocycle thereof. The nitrogen atom as the hetero atom of the heterocycle may form an imino group (NH group). The aromatic heterocyclic compound may be a compound represented by the following formula (III): 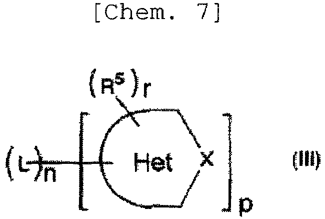 wherein the ring Het represents an aromatic heterocycle; X represents a hetero atom; R⁵ represents a non-reactive group; r is an integer of 0 to 3; and L, n, and p have the same meanings as defined above.
The composition may comprise an aromatic polyaldehyde compound having 2 to 4 formyl groups as reactive sites per molecule and an aromatic heterocyclic compound having 2 to 8 (for example, 2 to 4) unmodified α-carbon positions, as reactive sites (reactive sites to formyl group) per molecule, each of which is adjacent to a hetero atom of a heterocycle thereof; wherein at least one component of the aromatic polyaldehyde compound and the aromatic heterocyclic compound may have not less than 3 reactive sites.

The ratio of the aromatic polycarbonyl compound relative to the aromatic reactive component may be about 70/30 to 30/70, preferably about 60/40 to 40/60, and more preferably about 55/45 to 45/55, as a ratio of the former/the latter in terms of an equivalent ratio of the reactive site.

The composition comprising the aromatic polyaldehyde compound and the aromatic heterocyclic compound may further comprise an acid catalyst. The amount of the acid catalyst may be about 0.001 to 1 parts by weight relative to 1 part by weight of the total amount of the aromatic polyaldehyde compound and the aromatic heterocyclic compound.

The composition of the present inventionmay further comprise an organic solvent. The amount of the organic solvent may be about 0.1 to 200 parts by weight (for example, about 1 to 50 parts by weight) relative to 1 part by weight of the total amount of the aromatic polyaldehyde compound and the aromatic heterocyclic compound.

The present invention also includes an organic semiconductor obtainable by heat-treating the composition. The organic semiconductor may have a three-dimensional network structure substantially composed of a π-conjugated system as a whole. The organic semiconductor may have a structure in which a unit derived from the aromatic polycarbonyl compound may be coupled with a unit derived from the aromatic reactive component through at least one unit selected from the group consisting of a carbon-nitrogen double bond, an imidazole ring, an oxazole ring, a thiazole ring, a carbon-carbon single bond, and a carbon-carbon double bond. The organic semiconductor may be insoluble or sparingly (or hardly) soluble in an organic solvent.

Moreover, the present invention includes an organic-inorganic hybrid semiconductor comprising an inorganic semiconductor and the organic semiconductor formed on at least one side of the inorganic semiconductor. The inorganic semiconductor may comprise at least one metal selected from the group consisting of the group 2B, 3B, and 4B elements of the Periodic Table, or an oxide thereof. The organic inorganic semiconductor may for example be produced by applying the composition to at least one side of an inorganic semiconductor and then heat-treating the coated layer to form an organic semiconductor.

Further, the present invention includes an electronic device comprising the semiconductor (the organic semiconductor, the organic-inorganic hybrid semiconductor).

As used herein, the term "π-conjugated system" means a conjugated system which may contain an atom having an unshared electron pair (or a lone electron pair) (for example, nitrogen atom, oxygen atom, and sulfur atom) . As used herein, the combining form "poly" in the term "aromatic polycarbonyl compound" means that the compound has not less than two carbonyl groups, and the combining form "poly" in the term "aromatic polyamine" mean that the compound has not less than two amino groups (reactive groups to carbonyl group) . Further, as used herein, the term "ring having aromaticity" means not only an aromatic ring but also a ring having a circular structure formed by coupling a plurality of aromatic rings (e.g., pyrrole rings) with each other (for example, in a sequential form) to form a π-conjugated system (for example, -N=, -C=), such as a porphin ring (e.g., a porphyrin derivative and phthalocyanine).

### EFFECTS OF THE INVENTION

According to the composition of the present invention, since at least one component among an aromatic polycarbonyl compound, an aromatic polyamine, and an aromatic heterocyclic compound has not less than 3 carbonyl groups (reactive groups containing carbonyl group) or amino groups, or not less than 3 unmodified α-carbon positions as functional groups (reactive groups) or reactive sites, the composition forms, while advancing a reaction of these components, a three-dimensional network structure (a crosslinked structure) in which π-conjugated systems are linked. Accordingly, the organic semiconductor formed with the composition has a low resistance and a high conductivity (carrier mobility). In particular, since the reaction easily proceeds, it is presumed that the organic semiconductor comprises one polymer coupled in three-dimensional network structure substantially composed of a π-conjugated system as a whole. The organic semiconductor formed with the composition forms a pseudo or quasi band structure as a whole, and in the carrier transfer mechanism the nonlocalized intramolecular electron transfer takes precedence over the intermolecular electron transfer (hopping). Thus the organic semiconductor has an extremely excellent conductivity. Moreover, since the intermolecular electron transfer is restrained, the electron transfer is not liable to be inhibited due to oxygen, water, and other impurities. Thus, the organic semiconductor formed with the composition functions as a semiconductor even in a purity (not more than 99%) lower than the purity (not less than 99.9%) necessary for the conventional organic semiconductor. Specifically, since the composition to be used in the present invention does not require special purification treatments (such as sublimation purification) which are necessary for the conventional organic semiconductor, the composition can be provided at a lower cost. Moreover, in the organic semiconductor having a three-dimensional network structure, since an absolute position of each component comprising the organic semiconductor is firmly held, each component is immovilized greatly even if an external energy is applied. Thus the change of the layer (or film) quality (e.g., crystallization) is inhibited, and the organic semiconductor has an excellent durability against heat or other factors and prevents shortening of the lifetime of a device formed with the composition. Further, since the organic semiconductor has an excellent solvent resistance, a coating composition containing an organic solvent can directly be applied to the organic semiconductor to form a laminated structure. The polymerizable components (or reactive components) contained in the composition of the present invention are soluble in a solvent, and the composition can be formed into a layer (or film) by a simple method (such as coating). Further, the composition containing an aromatic heterocyclic compound has a higher stability as a coating composition compared with the composition containing an aromatic polyamine and is useful for forming an organic semiconductor at a low temperature. The characteristics of the organic semiconductor (for example, conductivity and band gap) can easily be controlled by coordinating the species or amount of the polymerizable components (or reactive components).

Further, since the organic semiconductor of the present invention forms a pseudo or quasi band structure as a whole and is handled in the same manner as an inorganic semiconductor, the organic semiconductor easily forms a hybrid (or composite) with an inorganic semiconductor. In the organic-inorganic hybrid semiconductor, the organic semiconductor is combined with an inorganic semiconductor having a high carrier transfer to improve a photoelectric conversion efficiency, for example, in an application such as solar cell.

### BRIEF DESCRIPTION OF DRAWINGS

[Fig. 1] Fig. 1 is a graph showing rectification characteristics of a rectifier comprising an organic semiconductor of Example 1.
[Fig. 2] Fig. 2 is a graph showing an evaluation result of a photoelectric conversion of a photoelectric conversion element comprising an organic semiconductor of Example 1.
[Fig. 3] Fig. 3 is a graph showing an evaluation result of a photoelectric conversion of another photoelectric conversion element comprising an organic semiconductor of Example 1.
[Fig. 4] Fig. 4 is a graph showing an emission spectrum of an organic EL device comprising an organic semiconductor of Example 1.
[Fig. 5] Fig. 5 is a graph showing rectification characteristics of a rectifier comprising an organic semiconductor of Example 2.
[Fig. 6] Fig. 6 is a graph showing an evaluation result of a photoelectric conversion of a photoelectric conversion element comprising an organic semiconductor of Example 2.
[Fig. 7] Fig. 7 is a graph showing rectification characteristics of a rectifier comprising an organic semiconductor of Example 3.
[Fig. 8] Fig. 8 is a graph showing an evaluation result of a photoelectric conversion of a photoelectric conversion element comprising an organic semiconductor of Example 3.
[Fig. 9] Fig. 9 is a graph showing an evaluation result of a photoelectric conversion of a photoelectric conversion element comprising an organic semiconductor of Example 3.
[Fig. 10] Fig. 10 is a graph showing rectification characteristics of a rectifier comprising an organic semiconductor of Example 4.
[Fig. 11] Fig. 11 is a graph showing an evaluation result of a photoelectric conversion of a photoelectric conversion element comprising an organic semiconductor of Example 4.
[Fig. 12] Fig. 12 is a graph showing HOMO and LUMO values of organic semiconductors of Examples 1 to 4.
[Fig. 13] Fig. 13 is a graph showing conductive properties of organic semiconductors of Examples 1 to 4.
[Fig. 14] Fig. 14 is a graph showing rectification characteristics of a rectifier comprising an organic semiconductor of Example 5.
[Fig. 15] Fig. 15 is a graph showing an emission spectrum of an organic EL device comprising an organic semiconductor of Example 5.
[Fig. 16] Fig. 16 is a graph showing rectification characteristics of a rectifier comprising an organic semiconductor of Comparative Example 1.
[Fig. 17] Fig. 17 is a graph showing rectification characteristics of a rectifier comprising an organic semiconductor of Example 6.
[Fig. 18] Fig. 18 is a graph showing an evaluation result of a photoelectric conversion (light response property) of a photoelectric conversion element comprising an organic semiconductor of Example 6.
[Fig. 19] Fig. 19 is a graph showing rectification characteristics of a rectifier comprising an organic semiconductor of Example 7.
[Fig. 20] Fig. 20 is a graph showing an evaluation result of a photoelectric conversion (light response property) of a photoelectric conversion element comprising an organic semiconductor of Example 7.
[Fig. 21] Fig. 21 is a graph showing rectification characteristics of a rectifier comprising an organic semiconductor of Example 8.
[Fig. 22] Fig. 22 is a graph showing an evaluation result of a photoelectric conversion (light response property) of a photoelectric conversion element comprising an organic semiconductor of Example 8.
[Fig. 23] Fig. 23 is a graph showing rectification characteristics of a rectifier comprising an organic semiconductor of Example 9.
[Fig. 24] Fig. 24 is a graph showing an evaluation result of a photoelectric conversion (light response property) of a photoelectric conversion element comprising an organic semiconductor of Example 9.
[Fig. 25] Fig. 25 is a graph showing rectification characteristics of a rectifier comprising an organic semiconductor of Example 10.
[Fig. 26] Fig. 26 is a graph showing an evaluation result of a photoelectric conversion (light response property) of a photoelectric conversion element comprising an organic semiconductor of Example 10.
[Fig. 27] Fig. 27 is a graph showing rectification characteristics of a rectifier comprising an organic semiconductor of Example 12.
[Fig. 28] Fig. 28 is a graph showing an evaluation result of a photoelectric conversion (light response property) of a photoelectric conversion element comprising an organic semiconductor of Example 12.
[Fig. 29] Fig. 29 is a graph showing rectification characteristics of a rectifier comprising an organic semiconductor of Example 13.
[Fig. 30] Fig. 30 is a graph showing an evaluation result of a photoelectric conversion (light response property) of a photoelectric conversion element comprising an organic semiconductor of Example 13.

### DESCRIPTION OF EMBODIMENTS

### [Crosslinkable composition (or coating composition)]

The composition (crosslinkable or polymerizable composition) of the present invention comprises a polymerizable component (or reactive component) having a functional group (reactive site) which can form a π-conjugated bond [for example, a carbon-nitrogen double bond (-C=N-), a carbon-carbon single bond (-C-C-), a carbon-carbon double bond (-C=C-), a carbon-carbon triple bond (-C≡C-), an amide bond (-NHCO-), an imidazole ring, an oxazole ring, and a thiazole ring] by a reaction. The polymerizable component (or reactive component) has functional groups (reactive sites), which can form a π-conjugated bond, of not less than 2 (for example, about 2 to 8, preferably about 2 to 6, and more preferably about 2 to 4) . In particular, at least one polymerizable component (or reactive component) has functional groups (reactive sites) of not less than 3 (for example, about 3 to 8, preferably about 3 to 6, and more preferably about 3 to 4). The polymerizable component can therefore form a three-dimensional network structure (a crosslinked structure) by a polymerization reaction. Moreover, since the polymerizable component has a π-conjugated system structure (usually, an aromatic ring) in itself, the resulting polymer can be three-dimensionally electroconductive throughout (or as a whole).

The composition of the present invention comprises an aromatic polycarbonyl compound having a carbonyl group as a reactive site and at least one aromatic reactive component selected from the group consisting of an aromatic polyamine and an aromatic heterocyclic compound. The aromatic polyamine has an amino group as a reactive site, and the aromatic heterocyclic compound has an unmodified (or unsubstituted) α-carbon position, as a reactive site, adjacent to a hetero atom of the heterocycle thereof. Moreover, when the aromatic reactive component is the aromatic heterocyclic compound, an aromatic polyaldehyde compound is used as the aromatic polycarbonyl compound. Specifically, the present invention includes (1) an embodiment in which the composition comprises the aromatic polycarbonyl compound and the aromatic polyamine, (2) an embodiment in which the composition comprises the aromatic polyaldehyde compound and the aromatic heterocyclic compound, and (3) an embodiment in which the composition comprises the aromatic polyaldehyde compound, the aromatic polyamine, and the aromatic heterocyclic compound.

The composition of the embodiment (1) of the present invention comprises a combination for forming a carbon-nitrogen double bond(-C=N-),an amide bond(-NHCO-), an imidazole ring, an oxazole ring, or a thiazole ring, that is, a combination of a π-conjugated system compound containing a plurality of carbonyl groups (e.g. , an aromatic polycarbonyl compound) and a π-conjugated system compound containing a plurality of amino groups (e.g., an aromatic polyamine), in view of the easiness of the reaction. At least one compound among these compounds has not less than 3 reactive sites [amino groups or carbonyl groups (carbonyl-containing groups, carbonyl groups reactive to amino groups) ] as functional groups in one molecule thereof.

The composition of the embodiment (2) of the present invention comprises a combination for forming a carbon-carbon single bond (-C-C-) or a carbon-carbon double bond (-C=C-), that is, a combination of a π-conjugated system compound containing a plurality of formyl groups (an aromatic polyaldehyde compound) and a π-conjugated system heterocyclic compound containing a plurality of reactive sites (an aromatic heterocyclic compound). In the composition, at least one component of the aromatic polycarbonyl compound and the aromatic heterocyclic compound has not less than 3 reactive sites (formyl groups (aldehyde groups) or unmodified α-carbon positions) in one molecule thereof. The composition has a high stability and can form an organic semiconductor by heat-treatment at a low temperature.

The composition of the embodiment (3) of the present invention corresponds to a composition comprising a combination of the embodiment (1) and the embodiment (2). Thus, in the composition according to the embodiment (3), at least one component selected from the group consisting of the aromatic polycarbonyl compound, the aromatic polyamine, and the aromatic heterocyclic compound has not less than 3 reactive sites [formyl groups (aldehyde groups), amino groups and/or unmodified α-carbon positions] in one molecule thereof.

These compositions of the embodiments (1) to (3) are suitable for forming an organic semiconductor (a high-molecular-weight type organic semiconductor). According to the present invention, the composition of the embodiment (1) or (2) can also form an organic semiconductor having a high performance.

### (Aromatic polycarbonyl compound)

The aromatic polycarbonyl compound is not particularly limited to a specific one as far as the aromatic polycarbonyl compound is an aromatic compound having a plurality of carbonyl groups (carbonyl-containing group). The aromatic polycarbonyl compound is usually represented by the following formula (I): 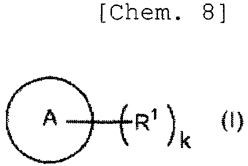 wherein A represents a ring having aromaticity, R¹ represents a carbonyl-containing group, and k is an integer of not less than 2.
In the formula (I), the ring having aromaticity represented by A (hereinafter, may simply be referred to as an aromatic ring) maybe an aromatic ring or a ring-assembly comprising aromatic rings. The aromatic ring may include an aromatic hydrocarbon ring [for example, a monocyclic aromatic hydrocarbon ring (e.g., benzene ring), a condensed polycyclic aromatic hydrocarbon ring (e.g., a condensed bicyclic hydrocarbon ring such as indene ring or naphthalene ring; a condensed tricyclic hydrocarbon ring such as acenaphthylene ring, fluorene ring, phenalene ring, anthracene ring, or phenanthrene ring; a condensed tetracyclic hydrocarbon ring such as pyrene ring or naphthacene ring; a condensed pentacyclic hydrocarbon ring such as pentacene ring or picene ring; a condensed hexacyclic hydrocarbon ring such as hexaphene ring or hexacene ring; and a condensed heptacyclic hydrocarbon ring such as coronene ring)], an aromatic heterocycle [for example, a monocyclic heterocycle (e.g., a 5-membered heterocycle containing sulfur atom, such as thiophene ring; a 5-membered heterocycle containing nitrogen atom, such as pyrrole ring, pyrazole ring, or imidazole ring; a 5-membered heterocycle containing oxygen atom, such as furan ring; a 5-membered heterocycle containing nitrogen atom and oxygen atom, such as oxazole ring or oxadiazole ring; and a 5-membered heterocycle containing nitrogen atom and sulfur atom, such as thiazole ring or thiadiazole ring), a polycyclic heterocycle (e.g., a condensed bicyclic heterocycle such as quinoline ring; a condensed tricyclic heterocycle such as xanthene ring, carbazole ring, acridine ring, phenanthridine ring, phenazine ring, phenothiazine ring, or phenoxazine ring; porphyrin; and phthalocyanine)], or a derivative thereof (e.g., a carbocyclic ketone such as anthraquinone, and a heterocyclic ketone such as pirazolone), and other rings. These aromatic rings mayhave a substituent (e.g., a non-reactive group R² described below).

The aromatic rings in the ring-assembly may comprise a single aromatic ring alone as exemplified above or not less than two species of the aromatic rings as exemplified above.

The ring-assembly comprising aromatic rings may include, for example, a ring-assembly in which a plurality of aromatic rings are directly linked each other or with a single bond [for example, a bicyclic assembly such as biphenyl, and a tricyclic assembly such as a terphenyl (e. g. , p-terphenyl), and a tetracyclic assembly such as 1,3,5-triphenylbenzene]; and a ring-assembly in which a plurality of aromatic rings are coupled (or joined) to each other through a linker (or a unit or a linking group) {for example, a bicyclic assembly [e.g., a ring-assembly containing oxygen atom as a linker (e.g., a diaryl ether such as phenoxybenzene); a ring-assembly containing sulfur atom as a linker (e.g., a diaryl thioether such as phenylthiobenzene); a ring-assembly containing vinylene group as a linker (e.g., a 1,2-diarylethene such as stilbene); a ring-assembly containing an azo group as a linker (e.g., an azoarene (a 1,2-diaryldiazene) such as azobenzene)]; and a tricyclic assembly [for example, a ring-assembly containing nitrogen atom as a linker (e.g., a triarylamine such as triphenylamine)]}.

Examples of the carbonyl-containing group represented by R¹ may include formyl group (aldehyde group) ; a formyl-containing group such as a group -(CH=CH)ₘ-CHO (wherein m is an integer of not less than 0, for example, 0 to 10, preferably 0 to 5, and more preferably 0 to 2), e.g., 2-formylvinyl group; a ketone-containing group such as an acyl group (e. g. , a C₂₋₅acyl group such as acetyl group) ; a carboxyl group; a lower alkoxycarbonyl group (a C₁₋₂alkoxycarbonyl group); and a halocarbonyl group (e.g., a chlorocarbonyl group). Each of the groups represented by R¹ may be the same or different from each other, and is usually the same.

The number k of the substituents R¹ is not less than 2 and may for example be about 2 to 10, preferably about 2 to 8, and more preferably about 2 to 6 (particularly about 2 to 4).

Specifically, the compound represented by the formula (I) includes a compound represented by the following formula (Ia) (forexample, an aromatic polyaldehyde compound and an aromatic polycarboxylic acid). 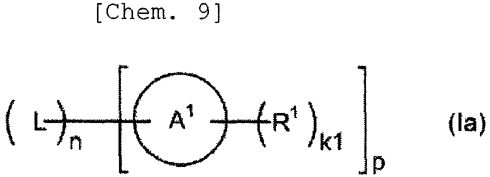 In the formula, L represents a linker, A¹ represents a ring having aromaticity, R¹ has the same meanings as defined above, n is 0 or 1, k1 is an integer of not less than 1, p is an integer of not less than 1; with the proviso that k1 x p is an integer of not less than 2.
In the formula (Ia), "k1 x p is an integer of not less than 2" means that the total number of the groups R¹ contained in the molecule is not less than 2.

In the formula (Ia), as the ring having aromaticity (or the aromatic ring) represented by A¹, there may be mentioned the same ring as the ring A described above. Among these rings, a monocyclic or condensed bi- to icosa-cyclic aromatic ring (for example, a condensed bi- to deca-cyclic aromatic ring) is preferred. In particular, the preferred ring includes a monocyclic or condensed bi- to hepta-cyclic arene ring (e.g., a monocyclic or condensed bi- to tetra-cyclic arene ring such as benzene ring or naphthalene ring) and a condensed bi- to hepta-cyclic nitrogen-atom-containing heterocycle (e.g., a condensed bi- to tetracyclic nitrogen-atom-containing heterocycle such as carbazole ring), particularly, a C₆₋₂₄arene ring (for example, a C₆₋₁₄arene ring, particularly a C₆₋₁₀arene ring) such as benzene ring or naphthalene ring. When p is an integer of not less than 2, the species of each ring A¹ may be the same or different from each other, and is usually the same.

The linker (or unit or linking group) represented by L may include, for example, a hetero atom such as oxygen atom, sulfur atom, nitrogen atom, boron atom, or phosphorus atom; a linker containing a plurality of hetero atoms (e. g. , azo group and disulfide group); a linker corresponding to ethylene (e.g., vinylene group); a linker corresponding to acetylene (ethynylene group); a linker corresponding to an aromatic ring (or a bi- to poly-valent group); and a linker containing a combination thereof [for example, a group represented by the following formula (Ib)]. With respect to the linker corresponding to an aromatic ring, the aromatic ring may include the same aromatic ring as the ring A. Among these aromatic rings, the preferred one includes a ring selected from the group consisting of a monocyclic or condensed bi- to hepta-cyclic aromatic hydrocarbon ring (e.g., a monocyclic or condensed bi- to tetra-cyclic arene ring such as benzene ring, naphthalene ring, or fluorene ring), a heterocycle containing oxygen atom and nitrogen atom (e.g. , a 5-membered heterocycle such as oxazole ring or oxadiazole ring), and a porphyrin ring.

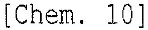

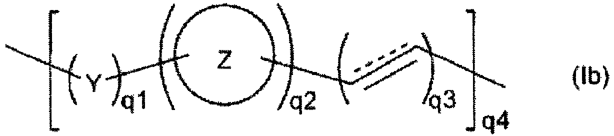

In the formula, Y represents oxygen atom, sulfur atom, or azo group, Z represents a ring having aromaticity, each one of q1, q2, and q3 is 0 or 1, q4 is an integer of not less than 1; with the proviso that q1+q2+q3 is an integer of not less than 1, and (q1+q2+q3) x q4 is an integer of not less than 2.
In the formula, the following chemical bond: 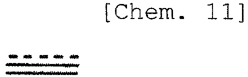 indicates a double bond or a triple bond.

In the formula (Ib), as the ring having aromaticity represented by the ring Z, there may be mentioned the same ring as the ring A. The ring Z preferably includes a C₆₋₂₄arene ring (for example, a C₆₋₁₀arene ring) such as benzene ring or naphthalene ring. The ring Z may have a substituent (e.g., a non-reactive group R² described below). Moreover, when q4 is an integer of not less than 2, the species of each Z (or Y) may be the same or different from each other, and each number q1 (or q2 or q3) may be the same or different from each other.

In the formula (Ia), the linker L may be a fullerene (or a fullerene unit). The linker L and/or the aromatic ring A¹ may have a fullerene (or a fullerene unit) as a substituent.

The repeating number q4 of units comprising at least one member selected from the group consisting of Y, Z, and vinylene group (or ethynylene group), is not particularly limited to a specific one as far as the number is not less than 1, and may for example be about 1 to 10, preferably about 1 to 8, and more preferably about 1 to 5. The total number of q1, q2, and q3 in the unit, (q1+q2+q3), is not particularly limited to a specific one as far as the total number is not less than 1, and may be about 1 to 3 and preferably about 1 to 2.

The total number of q1, q2, and q3 in the formula (Ib), [(q1+q2+q3) x q4], is not particularly limited to a specific one as far as the total number is not less than 2, and may for example be about 2 to 10, preferably about 2 to 8, and more preferably about 2 to 6 (for example, about 3 to 5).

Specifically, the group represented by the formula (Ib) may include an arenediazo group which has an arylene group having an azo group at each terminal thereof [e.g., the following formula (Ib-1)], a diarylethenediazo group which has vinylene group having an azo group through an arylene group at each terminal thereof [e.g., the following formula (Ib-2)], an arylarenedioxy group which has an arylarene-diyl group having an oxygen atom at each terminal thereof [e.g., the following formula (Ib-3)], a group in which a plurality of ethynylene groups are joined to an arene ring [e.g., an arenediethynylene group such as the following formula (Ib-4)], and other groups. 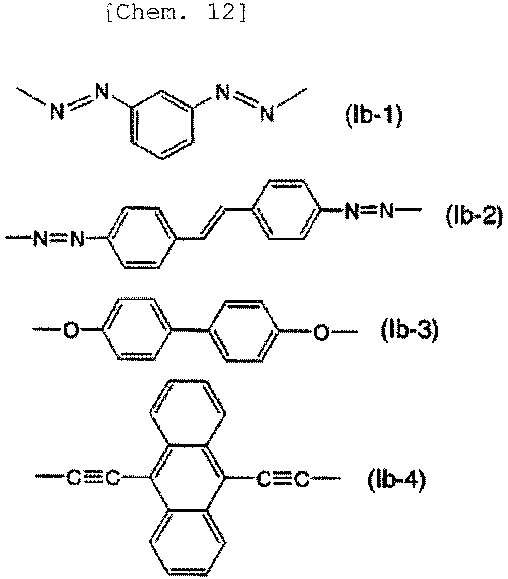 Among these linkers, the preferred linker may include oxygen atom, sulfur atom, nitrogen atom, disulfide group, vinylene group, a di- to tetra-valent aromatic carbocyclic (or hydrocarbon ring) or heterocyclic group [for example, a divalent carbocyclic group (e.g., phenylene group and 9,9-fluorene-diylgroup), a divalent heterocyclic group (e.g., an oxazole-diyl group such as 2,5-oxazole-diyl group, and an oxadiazole-diyl group such as 2,5-oxadiazole-diyl group), a trivalent carbocyclic group (e.g., a C₆-₂₄arene-triyl group such as 1,3,5-benzene-triyl group), and a tetravalent heterocyclic group (e.g., a porphyrin-tetrayl group such as 5,10,15,20-porphyrin-tetrayl group)], a group which has an arylene group (a C₆₋₂₄arylene group such as phenylene group) having an azo group at each terminal (or end) thereof, a group which has vinylene group having an azo group through an arylene group (a C₆₋₂₄arylene group such as phenylene group) at each terminal (or end) thereof, or a group which has an arylarene-diyl group (e.g., a biC₆₋₂₄aryl-diyl group such as biphenyl-diyl group) having an oxygen atom at each terminal (or end) thereof.

The number p (the number corresponding to the valence of the linker L) is suitably selected depending on the species of the linker L, and may be not less than 1 [for example, about 1 to 10, preferably about 1 to 8, and more preferably about 1 to 6 (e.g., about 1 to 4, particularly, about 1 to 3)]. The case of "n=0 and p=1" means that the formula (Ia) represents an ring A¹ having a plurality of carbonyl-containing groups; the case of "n=0 and p=2" means that two rings A¹ are linked directly or with a single bond.

As the carbonyl-containing group represented by R¹, a formyl-containing group (such as formyl group or 2-formylvinyl group) and a carboxyl group are preferred, and formyl group is particularly preferred. When k1 is an integer of not less than 2, the species of the group R¹ may be different from each other. The species of the group R¹ is usually the same.

The number k1 of the group R¹ is not particularly limited to a specific one as far as the number k1 is an integer of not less than 1 and the total number (k1 x p) of the group R¹ in the molecule is not less than 2. For example, in the case of p=1, k1 is not less than 2 and may for example be about 2 to 10, preferably about 2 to 8, and more preferably about 2 to 6 (for example, about 2 to 4, particularly 3). In the case where p is an integer of not less than 2, k1 is not less than 1 and may for example be about 1 to 10, preferably about 1 to 5, and more preferably about 1 to 3 (for example, 1 to 2, particularly 1) . When p is an integer of not less than 2, each k1 may be different from each other, and is usually the same.

The number k1 x p is not particularly limited to a specific one as far as the number is not less than 2, and may for example be about 2 to 10, preferably about 2 to 8, and more preferably about 2 to 6 (e.g., about 2 to 4, particularly 3 or 4).

There is no particular limitation as to the position of the group R¹, and the position of a plurality of groups R¹ as substituents on one aromatic ring A¹ is preferably non-ortho position.

The aromatic ring A¹ may have a substituent (e.g., a non-reactive group). The compound represented by the formula (Ia) may be a compound represented by the following formula (Ic):

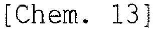

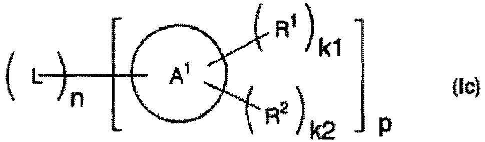

wherein R² represents a non-reactive group, k2 is an integer of not less than 0, and L, A¹, R¹, n, k1, and p have the same meanings as defined above.
The term "non-reactive group" represented by the group R² means a group non-reactive (or inactive) to the reaction between an amino group and a carbonyl-containing group. The non-reactive group may include a hydrocarbon group, a halogenated hydrocarbon group, an alkoxy group, a cycloalkoxy group, an aryloxy group, an aralkyloxy group, an alkylthio group, a cycloalkylthio group, an arylthio group, an aralkylthio group, an N,N-di-substituted amino group, a sulfo group, a sulfonate group (such as sodium sulfonate group), and other groups.

Examples of the hydrocarbon group may include an alkyl group [for example, a straight chain or branched chain C₁₋₁₂alkyl group (preferably a straight chain or branched chain C₁₋₁₀alkyl group) such as methyl group, ethyl group, propyl group, isopropyl group, butyl group, t-butyl group, pentyl group, hexyl group, or 2-ethylhexyl group], an alkenyl group (e. g. , a C₂₋₆alkenyl group such as vinyl group), a cycloalkyl group (e.g., a C₅₋₈cycloalkyl group such as cyclohexyl group), an aryl group [for example, a C₆₋₁₀aryl group such as phenyl group, an alkylphenyl group (a C₁₋₄alkylphenyl group such as a mono- or dimethylphenyl group (e.g., tolyl group, 2-methylphenyl group, and xylyl group)), or naphthyl group], and an aralkyl group (e.g., a C₆₋₁₀aryl-C₁₋₄alkyl group such as benzyl group).

As the halogenated hydrocarbon group, there may be mentioned a group in which the hydrogen atom of the above-mentioned hydrocarbon group is replaced with a halogen atom (such as fluorine, chlorine, or bromine), for example, a haloC₁₋₆alkyl group such as trichloromethyl group, trifluoromethyl group, or tetrafluoroethyl group (e.g., fluoromethyl group).

Examples of the alkoxy group may include a straight chain or branched chain C₁₋₁₀alkoxy group (preferably a C₁₋₆alkoxy group) such as methoxy group, ethoxy group, propoxy group, n-butoxy group, or t-butoxy group. As the cycloalkoxy group, there may be mentioned a C₅₋₈cycloalkyloxy group such as cyclohexyloxy group, and other groups. Examples of the aryloxy group may include a C₆₋₁₀aryloxy group such as phenoxy group. As the aralkyloxy group, there may be mentioned a C₆₋₁₀aryl-C₁₋₄alkyloxy group such as benzyloxy group, and other groups.

The alkylthio group, the cycloalkylthio group, the arylthio group, and the aralkylthio group may include groups corresponding to the alkoxy group, the cycloalkoxy group, the aryloxy group, and the aralkyloxy group, respectively.

The N,N-di-substituted amino group may include an N,N-dialkylamino group (an N,N-diC₁₋₆alkylamino group such as N,N-dimethylamino group), and other groups.

There is no particular limitation as to the position of the group R². When the total number (k2 x p) of the groups R² in the molecule is an integer of not less than 2, the species of each group R² may be different from each other, and is usually the same.

The number k2 is not particularly limited to a specific one as far as the number is not less than 0, and may for example be about 0 to 5, preferably about 0 to 3, and more preferably about 0 to 2 (for example, 0 or 1, particularly 0). When p is an integer of not less than 2, each k2 may be different from each other. Each k2 is usually the same.

The number k2 x p is not particularly limited to a specific one as far as the number is not less than 0, and may for example be about 0 to 10, preferably about 0 to 6, and more preferably about 0 to 4 (particularly about 0 to 2).

These compounds may be used alone or in combination. Among the compounds represented by the formula (Ia), for example, the following compounds (a1) to (a4) are preferred.

(a1) A compound in which the ring A¹ is a monocyclic or condensed bi- to hepta-cyclic aromatic hydrocarbon ring (e.g., a C₆₋₂₄arene ring such as benzene ring, naphthalene ring, anthracene ring, or pyrene ring) or a condensed bi- to hepta-cyclic aromatic heterocycle (e.g., a nitrogen-atom-containing heterocycle such as carbazole ring), n is 0, k1 is 2 to 4 (e.g., 2 or 3), and p is 1.

Examples of the compound may include a di- to tetraformylarene, and a compound in which a formyl group of the di- to tetraformylarene is replaced with a carboxyl group. The di-to tetraformylarene may include, for example, a diformylarene (e.g., a diformylC₆₋₂₀arene) such as diformylanthracene; a triformylarene (e.g., a triformylC₆₋₂₀arene) such as 1,3,5-triformylbenzene; a tetraformylarene (e.g., a tetraformylC₆₋₂₀arene) such as tetraformylpyrene; and a heterocyclic dialdehyde (e.g., a 5- or 6-memberd heterocyclic dialdehyde, and a condensed heterocyclic dialdehyde of a 5- or 6-memberd heterocycle and a benzene ring) which may have a substituent (e.g., an alkyl group such as a C₁₋₁₂alkyl group), such as 9-(2-ethylhexyl)carbazole-3,6-dicarbaldehyde.

(a2) A compound (ring-assembly compound) in which the ring A¹ is a monocyclic or condensed bi- to hepta-cyclic aromatic hydrocarbon ring (e.g., a C₆₋₂₄arene ring such as benzene ring or naphthalene ring), n is 0, k1 is 1 or 2, and p is 2 or 3.

Examples of the compound may include a ring-assembly compound in which a plurality of [about 2 to 10 (preferably about 2 to 5)] arene rings are coupled (or joined), for example, a diformylbiaryl (a diformylbiC₆₋₁₂aryl, in which an arene ring having formyl group is located at each terminal (or end) thereof) such as 2,2'-diformylbiphenyl or 4,4'-diformylbiphenyl; a diformylterC₆₋₁₂aryl, in which an arene ring having formyl group is located at each terminal (or end) thereof, such as 4,4"-diformylterphenyl; a diformylbithiophene such as 2,2'-bithiophene-5,5'-dicarbaldehyde; and a diformylterthiophene such as 2,2':5',2"-terthiophene-5,5"-dicarbaldehyde; and a compound having a carboxyl group instead of formyl group in each one of these compounds.

(a3) A compound in which the ring A¹ is a monocyclic or condensed bi- to hepta-cyclic aromatic hydrocarbon ring (e. g. , a C₆₋₂₄arene ring such as benzene ring or naphthalene ring); the linker L is nitrogen atom, oxygen atom, sulfur atom, vinylene group, a di- to tetra-valent aromatic carbocyclic or aromatic heterocyclic group [for example, a di- to tetra-valent group corresponding to an aromatic ring selected from the group consisting of an arene ring (for example, a C₆₋₂₄arene ring such as benzene ring or naphthalene ring) and a porphyrin ring, such as an arylene group (e.g., a C₆₋₂₄arylene group such as phenylene group), an arene-triyl group (e.g., a C₆₋₂₄arene-triyl group such as benzene-triyl group), or a porphyrin-tetrayl group]; n is 1; k1 is 1 or 2; and p is 2 to 4.

Examples of the compound may include a bis(formylaryl) ether such as bis(2-formylphenyl) ether (e.g., a bis (formylC₆₋₁₂aryl) ether); a 1,2-di(formylaryl)ethene such as 4,4'-diformylstilbene (e.g., a 1,2-bis(formylC₆₋₁₂aryl)ethene) ; a tri(formylaryl)amine such as tris(4-formylphenyl)amine (e.g., a tris(formylC₆₋₁₂aryl)amine) ; a tri(formylaryl)arene such as 1,3,5-tris(4-formylphenyl)benzene (e.g., a tris(formylC₆₋₁₂aryl)C₆₋₁₂arene); a tetra(formylaryl)porphyrin such as 5,10,15,20-tetrakis(4-formylphenyl)porphyrin (e.g., a tetrakis(formylC₆₋₁₂aryl)porphyrin); and a compound in which a formyl group is replaced with a carboxyl group in each one of these compounds.

(a4) A compound in which the ring A¹ is a porphyrin or phthalocyanine ring, n is 0, k1 is 2 to 4, and p is 1 [for example, 2,9,16,23-tetraformylphthalocyanine, and 3,10,17,24-tetraformylphthalocyanine].

These aromatic compounds may be used alone or in combination. The aromatic polycarbonyl compound (in particular, an aromatic polyaldehyde compound) preferably has a plurality of (e. g. , 2 to 4, particularly 3 to 4) reactive sites (such as formyl groups) in one molecule thereof. In particular, in view of the reactivity of the amino group and the α-carbon position, compounds, each having formyl group as the group R¹ in the compounds (a1) to (a4), are preferred (for example, compounds shown in Tables 1 to 3).

[Table 1]

**Table 1**

| L | n | p | k1 | Compound name | Structural formula |
|---|---|---|---|---|---|
| - | 0 | 1 | 2 | 9-(2-Ethylhexyl)carbazole-3,6-dicarbaldehyde | 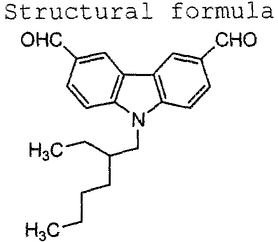 |
| - | 0 | 1 | 3 | 1, 3, 5-Triformylbenzene | 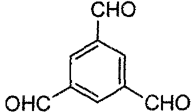 |
| - | 0 | 1 | 3 | | 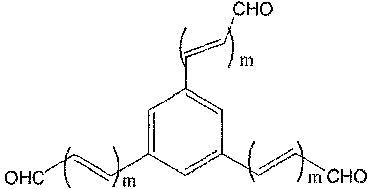 |
| - | 0 | 2 | 1 | 2,2'-Diformylbiphenyl | 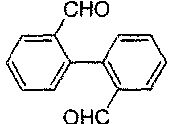 |
| - | 0 | 2 | 1 | 4,4'-Diformylbiphenyl | 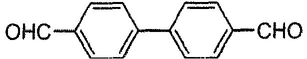 |

[Table 2]

**Table 2**

| L | n | p | k1 | Compound name | Structural formula |
|---|---|---|---|---|---|
| Oxygen atom | 1 | 2 | 1 | Bis(2-formylphenyl) ether | 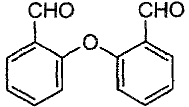 |
| Vinylene group | 1 | 2 | 1 | 4, 4' -Diformylstilbene | 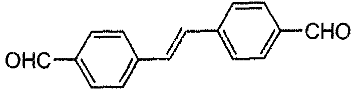 |
| Nitrogenatom | 1 | 3 | 1 | Tris(4-formylphenyl)amine | 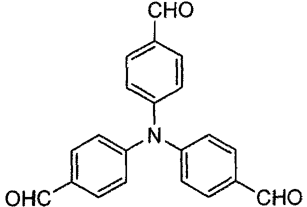 |
| Benzenetriyl group | 1 | 3 | 1 | 1,3,5-Tris (4-formylphenyl)benzene | 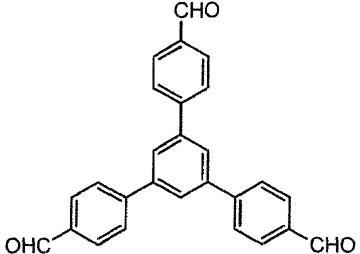 |

[Table 3]

**Table 3**

| L | n | p | k1 | Compound name | Structural formula |
|---|---|---|---|---|---|
| Linking group corresponding to porphyrin | 1 | 4 | 1 | 5,10,15,20-Tetrakis (4-formylphenyl)porphyrin | 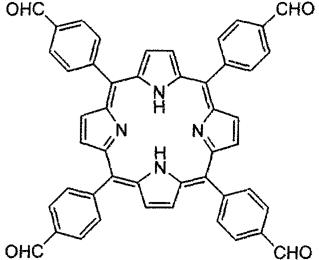 |
| Thiophenediyl group | 1 | 2 | 1 | 2,2':5',2"-terthiophene-5,5"-dicarbaldehyde | 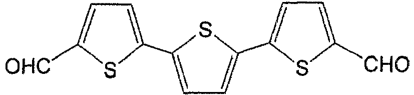 |
| - | 0 | 1 | 4 | Tetraformylpyrene | 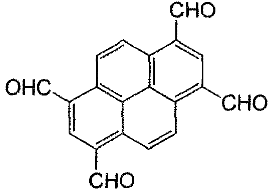 |
| - | 0 | 1 | 2 | Diformylanthracene | 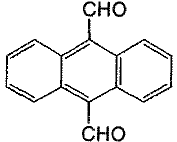 |

### (Aromatic polyamine)

The aromatic polyamine is not particularly limited to a specific one as far as the aromatic polyamine has a plurality of amino groups (primary amino groups). The aromatic polyamine is usually represented by the following formula (II): 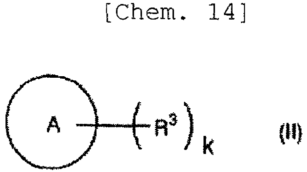 wherein R³ represents amino group, A and k have the same meanings as defined above.
Specifically, the compound represented by the formula (II) may include a compound represented by the following formula (IIa): 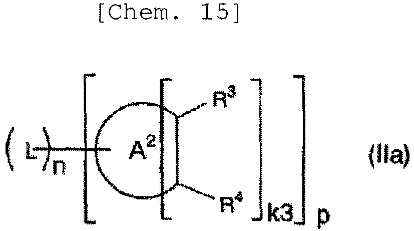 wherein A² represents a ring having aromaticity, R³ represents amino group, R⁴ represents hydrogen atom, an amino group, a mercapto group, or hydroxyl group, k3 is an integer of not less than 1, L, n, and p have the same meanings as defined above; with the proviso that, k3 x p is an integer of not less than 2.
In the formula (IIa), the case of "k3 is an integer of not less than 2" means that the ring A² has not less than two pairs of the groups R³ and R⁴, which are adjacent in the ortho-position. Moreover, the case of "k3 x p is an integer of not less than 2" means that the total number of pairs of R³ and R⁴ contained in the molecule is not less than 2.

In the formula (IIa), as the ring having aromaticity (or the aromatic ring) represented by A², there may be mentioned the same ring as the ring A¹. Among these rings, a monocyclic or condensed bi- to icosa-cyclic aromatic ring (for example, a condensed bi- to deca-cyclic aromatic ring) is preferred. In particular, the preferred ring includes a monocyclic or condensed bi- to hepta-cyclic hydrocarbon ring (e.g., a monocyclic or condensed bi- to tetra-cyclic hydrocarbon ring such as benzene ring, naphthalene ring, fluorene ring, pyrene ring, or anthraquinone ring), a condensed bi- to hepta-cyclic nitrogen-containing heterocycle (a condensed bi- to tetra-cyclic nitrogen-containing heterocycle such as carbazole ring or phenanthridine ring), particularly, a C₆₋₂₄arene ring (for example, a C₆₋₁₄arene ring, particularly a C₆₋₁₀arene ring) such as benzene ring or naphthalene ring. As the linker L, there may be mentioned the same linker as described in the formula (Ia).

In the formula (IIa), the linkerLmaybe a fullerene (or a fullerene unit). The linker L and/or the aromatic ring A² may have a fullerene (or a fullerene unit) as a substituent.

The number k3 of pairs of the groups R³ and R⁴, which are in the ortho position, is not particularly limited to a specific one as far as the number k3 is an integer of not less than 1 and the total number (k3 x p) of pairs of the groups R³ and R⁴ contained in the molecule is not less than 2. For example, in the case of p=1, k3 is not less than 2 and may for example be about 2 to 10, preferably about 2 to 8, and more preferably about 2 to 6 (for example, about 2 to 4, particularly 2). In the case where p is an integer of not less than 2, k3 is not less than 1 and may for example be about 1 to 10, preferably about 1 to 5, and more preferably about 1 to 3 (for example, 1 to 2, particularly 1) . When p is an integer of not less than 2, each k3 may be different from each other, and is usually the same.

In the case where k3 x p is an integer of not less than 2, the group R⁴ be different from each other, and is usually the same.

The substituents R³ and R⁴ are positioned on the ortho position of the ring A². The position of the group R³ is not particularly limited to a specific one, and a plurality of groups R³ on one aromatic ring A² are preferably positioned on the non-ortho position.

The aromatic ring A² may have a substituent (e.g., a non-reactive group). The compound represented by the formula (IIa) may be a compound represented by the following formula (IIb): 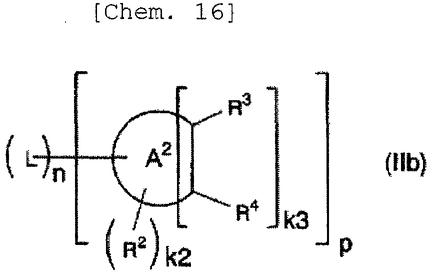 wherein A², L, R² , R³, R⁴, n, k2, k3, and p have the same meanings as defined above.
These compounds may be used alone or in combination. Among the compounds represented by the formula (IIa), for example, the following compounds (b1) to (b4) are preferred.

(b1) A compound in which the ring A² is a monocyclic or condensed bi- to hepta-cyclic aromatic hydrocarbon ring (e. g. , benzene ring, naphthalene ring, fluorene ring, pyrene ring, anthraquinone ring, and coronene ring), or a condensed bi- to hepta-cyclic aromatic heterocycle (e.g., a nitrogen-atom-containing heterocycle such as carbazole ring or phenanthridine ring), n is 0, k3 is 2 to 4 (for example, 2 or 3), and p is 1.

Examples of the compound may include a di- to triaminoarene (e.g., a di-to triaminoC₆₋₂₀arene) which may have a substituent, such as phenylenediamine, diaminonaphthalene, diaminofluorene, diaminopyrene, 2,5-diamino-1,4-benzenedithiol, diaminocarbazole, diaminoanthraquinone, or diamino-6-phenylphenanthridine. As the substituent, there may be mentioned a C₁₋₁₀alkyl group, a C₆₋₁₀aryl group, hydroxyl group, a C₁₋₁₀alkoxy group, mercapto group, amino group, carbonyl group, and other groups.

(b2) A compound in which the ring A² is a monocyclic or condensed bi- to hepta-cyclic aromatic hydrocarbon ring (e. g. , a C₆₋₂₄arene ring such as benzene ring or naphthalene ring), n is 0, k3 is 1 or 2, and p is 2.

Examples of the compound may include a benzidine which may have a substituent, such as 2,2'-bis(trifluoromethyl)benzidine, 3,3'-diaminobenzidine, 3,5'-dihydroxybenzidine, or 3,5'-dimercaptobenzidine; and a naphthidine which may have a substituent, such as 3,3'-dimethylnaphthidine. As the substituent, there may be mentioned a C₁₋₁₀alkyl group, a haloC₁₋₁₀alkyl group, hydroxyl group, a C₁₋₁₀alkoxy group, a haloC₁₋₁₀alkoxy group, mercapto group, a C₁₋₁₀alkylthio group, a haloC₁₋₁₀alkylthio group, amino group, and other groups.

(b3) A compound in which the ring A² is a monocyclic or condensed bi- to hepta-cyclic aromatic hydrocarbon ring (e. g. , a C₆₋₂₄arene ring such as benzene ring or naphthalene ring);
the linker L is nitrogen atom, oxygen atom, sulfur atom, disulfide group, vinylene group, a di- to tetra-valent aromatic carbocyclic or heterocyclic group [for example, a di- to tetra-valent group corresponding to an aromatic ring selected from the group consisting of an arene ring (for example, a C₆₋₂₄arene ring such as benzene ring or naphthalene ring), a heterocycle having oxygen atom and nitrogen atom (for example, a monocyclic heterocycle such as 5-membered heterocycle), and a porphyrin ring; for example, an arylene group (e.g., phenylene group and 9,9-fluorene-diyl group), an arene-triyl group (e.g., benzene-triyl group), an oxazole-diyl group, an oxadiazole-diyl group, and a porphyrin-tetrayl group], a group which has an arylene group having an azo group at each terminal thereof, a group which has vinylene group having an azo group through an arylene group at each terminal thereof, or a group which has an arylarene-diyl group having an oxygen atom at each terminal thereof;
n is 1;
k3 is 1 or 2; and
p is 2 to 4.

Examples of the compound may include a tri(aminoaryl)amine [e.g., a tri(aminoC₆₋₁₀aryl)amine] such as tris(4-aminophenyl)amine; a bis(aminoaryl)sulfide [e.g., a bis(aminoC₆₋₁₀aryl)sulfide] such as bis(2-aminophenyl)sulfide; adi(aminoaryl)disulfide[e.g., a di(aminoC₆₋₁₀aryl)disulfide] such as di(2-aminophenyl)disulfide; a 1,2-di(aminoaryl)ethene [e.g., a di(aminoC₆₋₁₀aryl)ethene] such as 4,4'-diaminostilbene; a diaminobiaryl [e.g., a diaminobiC₆₋₁₀aryl] such as 4,4'-diaminobiphenyl; a diaminoteraryl [e.g., a diaminoterC₆₋₁₀aryl] such as 4,4"-diamino-p-terphenyl; a 9,9-bis(aminoaryl)fluorene [e.g., a 9,9-bis(aminoC₆₋₁₀aryl)fluorene] such as 9,9-bis(4-aminophenyl)fluorene; a di(aminoaryl)oxadiazole [e.g., a di(aminoC₆₋₁₀aryl)oxadiazole] such as 2,5-bis(4-aminophenyl)-1,3,4-oxadiazole; a bis(mono- to diaminoarylazo)arene [e.g., a bis(mono- to diaminoC₆₋₁₀arylazo)C₆₋₁₀arene] such as 1,3-bis(3,5-diamino-phenylazo)benzene; a bis(aminoarylazo)stilbene [e.g., a bis(aminoC₆₋₁₀arylazo)stilbene] which may have a substituent (e.g., a C₁₋₁₀alkyl group, hydroxyl group, a C₁₋₁₀alkoxy group, mercapto group, a C₁₋₁₀alkylthio group, sulfonyl group, and sulfinyl group), such as 4,4'-bis(4-amino-1-naphthylazo)-stilbene or 4,4'-bis(4-amino-1-naphthylazo)stilbene-2,2'-disulfonic acid; a bis(aminoaryloxy)biaryl [e.g., a bis(aminoC₆₋₁₀aryloxy)biC₆₋₁₀aryl] such as 4,4'-bis(4-aminophenoxy)biphenyl; and a tetra(aminoaryl)porphyrin [e.g., a tetra(aminoC₆₋₁₀aryl)porphyrin] such as 5,10,15,20-tetrakis(4-aminophenyl)porphyrin.

(b4) A compound in which the ring A² is a porphyrin or phthalocyanine ring, n is 0, k3 is 2 to 4, and p is 1.

The compound may include, for example, 2,9,16,23-tetraaminophthalocyanine and 3,10,17,24-tetraaminophthalocyanine.

These aromatic amines may be used singly or in combination. The aromatic polyamine preferably has a plurality of (e.g., 2 to 4, preferably 2 to 3) reactive sites (amino groups) in one molecule thereof. The aromatic amine is usually employed in combination with an aromatic polycarbonyl compound having a plurality of (for example, 2 to 4, particularly 3 to 4) reactive sites (e.g., formyl groups) in one molecule thereof (such as, particularly, an aromatic aldehyde compound). In particular, among the compounds represented by the formula (IIa), less toxic (or nontoxic) compounds (for example, compounds as shown in Tables 4 to 11) are preferred in view of easy handling.

[Table 4]

**Table 4**

| L | n | p | k3 | Compound name | Structural formula |
|---|---|---|---|---|---|
| - | 0 | 1 | 2 | 1,3-Phenylenediamine | 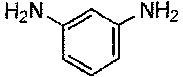 |
| - | 0 | 1 | 2 | 1,4-Phenylenediamine | 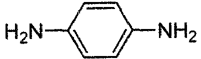 |
| - | 0 | 1 | 2 | 2,5-Diamino-1,4-benzenedithiol | 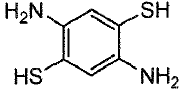 |
| - | 0 | 1 | 2 | 1,5-Diaminonaphthalene | 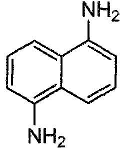 |
| - | 0 | 1 | 2 | 1,8-Diaminonaphthalene | 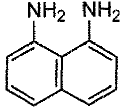 |
| - | 0 | 1 | 2 | 3,6-Diaminofluorene | 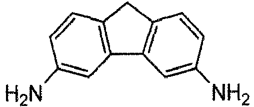 |

[Table 5]

**Table 5**

| L | n | p | k3 | Compound name | Structural formula |
|---|---|---|---|---|---|
| - | 0 | 1 | 2 | 3,6-Diaminocarbazole | 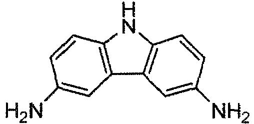 |
| - | 0 | 1 | 2 | 1,3-Diaminopyrene | 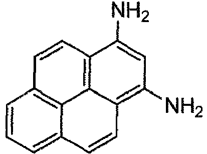 |
| - | 0 | 1 | 2 | 1,6-Diaminopyrene | 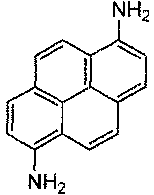 |
| - | 0 | 1 | 2 | 1,8-Diaminopyrene | 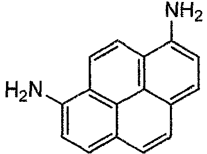 |

[Table 6]

**Table 6**

| L | n | p | k3 | Compound name | Structural formula |
|---|---|---|---|---|---|
| - | 0 | 1 | 2 | 1,4-Diaminoanthraquinone | 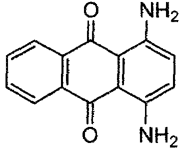 |
| - | 0 | 1 | 2 | 1,5-Diaminoanthraquinone | 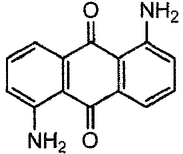 |
| - | 0 | 1 | 2 | 2,6-Diaminnanthraquinone | 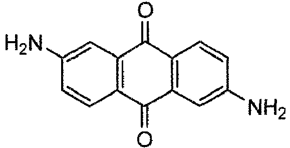 |
| - | 0 | 1 | 2 | 3,8-Diamino-6-phenylphenanthridine | 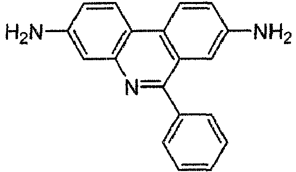 |

[Table 7]

**Table 7**

| L | n | p | k3 | Compound name | Structural formula |
|---|---|---|---|---|---|
| - | 0 | 2 | 1 | 2,2'-Bis(trifluoro methyl)benzidine | 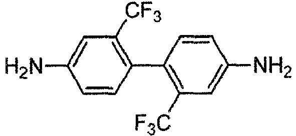 |
| - | 0 | 2 | 1 | 3,3'-Dimethylnaphthidine | 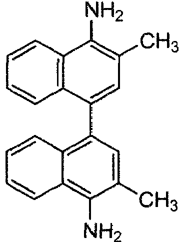 |
| - | 0 | 2 | 1 | 3,3'-Diaminobenzidine | 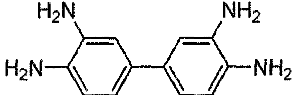 |
| - | 0 | 2 | 1 | 3,5'-Dihydroxybenzidine | 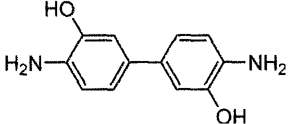 |

[Table 8]

**Table 8**

| L | n | p | k3 | Compound name | Structural formula |
|---|---|---|---|---|---|
| - | 0 | 2 | 1 | 3,5'-Dimercaptobenzidine | 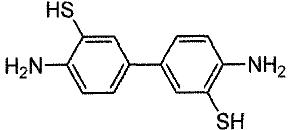 |
| Sulfur atom | 1 | 2 | 1 | Bis(2-aminophenyl)sulfide | 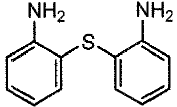 |
| Disulfide group | 1 | 2 | 1 | 2,2'-Dithiodianiline | 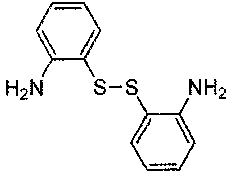 |
| Vinylene group | 1 | 2 | 1 | 4,4'-Diaminostilbene | 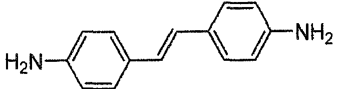 |
| Phenylene group | 1 | 2 | 1 | 4,4"-Diamino-p-terphenyl | 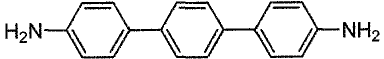 |

[Table 9]

**Table 9**

| L | n | p | k3 | Compound name | Structural formula |
|---|---|---|---|---|---|
| Linking group corresponding to oxadiazole ring | 1 | 2 | 1 | 2,5-Bis(4-aminophenyl) -1, 3, 4-oxadiazole | 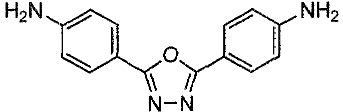 |
| Linking group corresponding to fluorene ring | 1 | 2 | 1 | 9,9-Bis(4-amino -phenyl)fluorene | 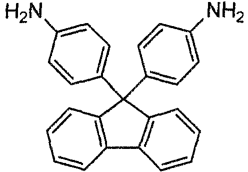 |
| Group represented by formula (Ib) | 1 | 2 | 2 | 1,33-Bis(3,5-diamino -phenylazo)benzene | 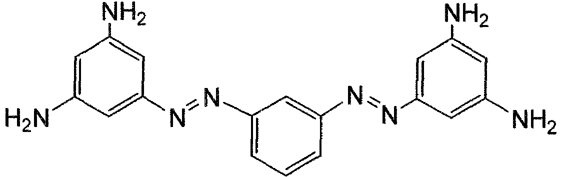 |

[Table 10]

**Table 10**

| L | n | p | k3 | Compound name | Structural formula |
|---|---|---|---|---|---|
| Group represented by formula (Ib) | 1 | 2 | 1 | 4,4'-Bis(4-amino-1-naphthylazo)-stilbene | 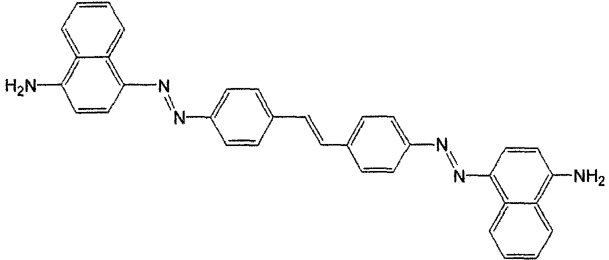 |
| Group represented by formula by formula (Ib) | 1 | 2 | 1 | 4,4'-Bis(4-amino-1-naphthylazo)-stilbene-2,2'-disulfonic acid | 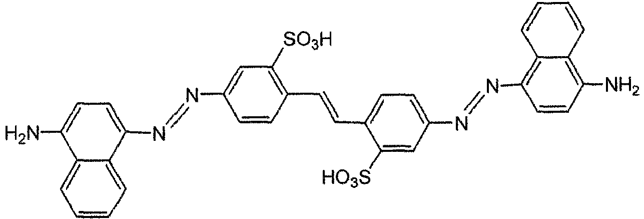 |
| Group represented by formula (Ib) | 1 | 2 | 1 | 4,4'-Bis(4-aminophenoxy) biphenyl | 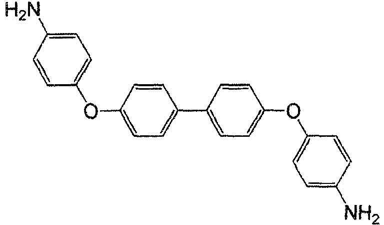 |

[Table 11]

**Table 11**

| L | n | p | k3 | Compound name | Structural formula |
|---|---|---|---|---|---|
| Nitrogen atom | 1 | 3 | 1 | Tris(4-aminophenyl)amine | 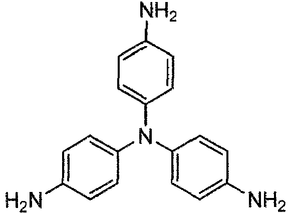 |
| Linking group corresponding porphyrin | 1 | 4 | 1 | 5,1-0,15, 20-Tetrakis (4-aminophenyl)porphyrin | 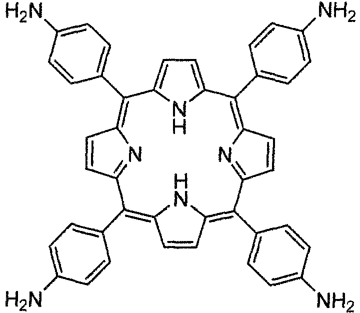 |

Among these compounds, the compound in which the group R⁴ is hydrogen atom is allowed to react with an aromatic polycarbonyl compound to produce a carbon-nitrogen double bond (-C=N-) or an amide bond (-NHCO-) by a reaction between an amino group represented by the group R³ and a carbonyl-containing group. Whereas, the compound in which the group R⁴ is amino group, hydroxyl group, or mercapto group(a ring-forming (or ring-formable)polyamine) is often allowed to react with an aromatic polycarbonyl compound (in particular, an aromatic polyaldehyde compound) to form a ring by participation of the adjacent groups R³ and R⁴ and a carbonyl-containing group. For example, (i) amino group as the group R⁴ forms imidazole ring; (ii) hydroxyl group as the group R⁴ forms oxazole ring; (iii) mercapto group as the group R⁴ forms thiazole ring.

The ratio of the aromatic polycarbonyl compound relative to the aromatic polyamine may for example be about 70/30 to 30/70, preferably about 60/40 to 40/60, and more preferably about 55/45 to 45/55 as a ratio of the former/the latter, in terms of an equivalent ratio of carbonyl group relative to amino group [specifically, a group reactive to carbonyl group (for example, in the formula (IIa), when the group R⁴ is amino group, hydroxyl group, or mercapto group, the groups R³ and R⁴ are regarded as one reactive group)].

### (Aromatic heterocyclic compound)

It is sufficient that the aromatic heterocyclic compound has a plurality of reactive sites (α-carbon sites, eachs adjacent to a hetero atom of a heterocycle thereof) to the aromatic polyaldehyde compound. The aromatic heterocyclic compound may be a monocyclic compound, a condensed cyclic compound, or a ring-assembly compound. The heterocyclic compound has a heterocycle of a 5- to 8-membered ring, preferably a 5- to 7-membered ring, and more preferably a 5- or 6-memberd ring. The heterocycle usually contains an aromatic 5-membered ring. Further, the heterocycle usually has at least one hetero atom selected from the group consisting of oxygen atom, sulfur atom, nitrogen atom, selenium atom, and tellurium atom. The hetero atom of the heterocycle may form imino group. These heterocyclic compounds may be used singly or in combination.

The aromatic heterocyclic compound may be represented by the following formula (III): 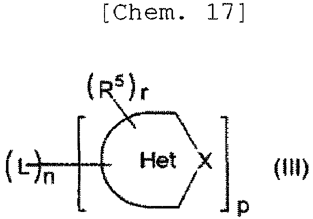 wherein a ring Het represents an aromatic heterocycle, X represents a hetero atom, R⁵ represents a non-reactive group, r is integer of 0 to 3, and L, n, and p have the same meanings as defined above.
The hetero atom X of the heterocycle may include, for example, oxygen atom, sulfur atom, nitrogen atom, selenium atom, tellurium atom, and other atoms. When the hetero atom X is nitrogen atom, X may form imino group (NH group). The heterocycle of the heterocyclic compound may contain a single hetero atom or may contain a plurality of the same or different hetero atoms. The hetero atom of the heterocycle is usually oxygen atom, sulfur atom, or nitrogen atom, particularly sulfur atom. The group X of the heterocycle may be imino group.

The aromatic heterocycle Het is a compound having the plurality of α-carbon sites per molecule. Representative examples of the monocyclic heterocycle may include a 5-membered heterocycle having 1 or 2 hetero atom (s) and a 6-membered heterocycle having 1 to 3 (e.g., 1 or 2) hetero atom(s). Moreover, the condensed cyclic heterocycle may representatively include, for example, a condensed heterocycle in which the same or different heterocycles are condensed, and a condensed heterocycle in which a benzene ring and a heterocycle are condensed. The heterocyclic compound usually contains a 5-membered aromatic heterocycle having at least one hetero atom selected from the group consisting of sulfur atom, oxygen atom, and nitrogen atom, as the hetero atom of the heterocycle.

The non-reactive group R⁵ may include, in addition to the same non-reactive group as the non-reactive group R^{2a}, a halogen atom (fluorine atom, chlorine atom, bromine atom, or iodine atom), a carboxyl group, an alkoxycarbonyl group (for example, a straight chain or branched chain C₁₋₁₀alkoxy-carbonyl group such as methoxycarbonyl group, ethoxycarbonyl group, or butoxycarbonyl group), a hydroxyalkyl group (for example, a hydroxyC₁₋₁₀alkyl group such as hydroxymethyl group, 2-hydroxyethyl group, 2-hydroxypropyl group, 3-hydroxypropyl group, or 4-hydroxybutyl group), a cyanoalkyl group (for example, a cyanoC₁₋₁₀alkyl group such as cyanomethyl group, 2-cyanoethyl group, or 3-cyanopropyl group), a carboxyalkyl group (for example, a carboxy-C₁₋₆alkyl group such as carboxymethyl group or 2-carboxyethyl group, and a dicarboxyC₁₋₆alkyl group such as dicarboxymethyl group or 2,2-dicarboxyethyl group), an alkoxycarbonylalkyl group (for example, a straight chain or branched chain C₁₋₁₀alkoxy-carbonyl-C₁₋₆alkyl group), dihydroxybornyl group (-B(OH)₂), a heterocyclic group (e.g., a 5- or 6-memberd heterocyclic group having a hetero atom selected from the group consisting of nitrogen atom, sulfur atom, and oxygen atom, such as pyridyl group or oxolane-yl group), a fullerene (or a fullerene unit), which may have a substituent, linked to a heterocyclic compound through a linking group, and other groups.

The non-reactive group R⁵ is practically a halogen atom, a straight chain or branched chain C₁₋₁₀alkyl group (such as methyl group, ethyl group, propyl group, isopropyl group, butyl group, s-butyl group, hexyl group, 2-ethylhexyl group, or octyl group), a C₅₋₁₀cycloalkyl group (such as cyclohexyl group), a C₆₋₁₀aryl group (such as phenyl group), a straight chain or branched chain C₁₋₁₀alkoxy group (such as methoxy group, ethoxy group, propoxy group, or butoxy group), a straight chain or branched chain C₁₋₁₀alkoxy-carbonyl group, a hydroxyC₁₋₄alkyl group, a cyanoC₁₋₄alkyl group, a carboxyC₁₋₄alkyl group, dihydroxybornyl group (-B(OH)₂), a fullerene unit linked or coupled through a linking group.

The number r is integer of 0 to 3, and usually 0 to 2 (e.g., 0 or 1).

As the linker L, there may be mentioned the same linker as described above, e.g., a linker corresponding to ethylene (e.g., vinylene group) and an arylene group (e.g., phenylene group). The linker L is practically vinylene group. The number n of the linkers L is 0 or 1.

In the formula (III), the linker L may be a fullerene (or a fullerene unit). The linker L and/or the aromatic heterocycle Het may have a fullerene (or a fullerene unit) as a substituent.
The repeating number p of the aromatic heterocycles Het may for example be about 1 to 1000, preferably about 1 to 500 (e.g., about 2 to 250), and more preferably about 1 to 200 (e.g., about 2 to 150) depending on the presence/absence or species of the non-reactive substituent R⁵. More specifically, a lower-boiling heterocyclic compound (for example, a monocyclic heterocyclic compound, particularly a monocyclic 5-membered heterocyclic compound) has a lowered film-formability. Use of a heterocyclic compound in the form of liquid at a room temperature (e.g., 20 to 25°C) easily deteriorates the performance of the resulting crosslinked coating layer formed by heat treatment after film forming. Thus the lower-boiling compound (or monocyclic heterocyclic compound) such as furan preferably increase a boiling point thereof by introducing the non-reactive substituent R⁵ into the compound. The preferred heterocyclic compound is in the form of solid at a room temperature and has a high solubility in a solvent. From considering such a viewpoint, the monocyclic heterocyclic compound (the compound in which r is "0" and n is "0") preferably has a boiling point of not lower than 50°C (for example, 75 to 350°C, preferably 100 to 300°C, more preferably 120 to 250°C).

Moreover, for a compound in which r is "0" or a compound having a lowered solubility in a solvent even in which r is "I" or even which has the non-reactive substituent R⁵ as a substituent, for example, a compound having a non-reactive substituent R⁵ having the small number of carbon atoms, such as a halogen atom or an aryl group, the number p may for example be about 1 to 10, preferably about 1 to 6, and more preferably about 2 to 4. For a heterocyclic compound in which r is "1" and which has, for improving the solubility in a solvent, a non-reactive substituent R⁵ (for example, an alkyl group (e.g., a straight chain or branched chain C₁₋₁₀alkyl group such as hexyl group) or an alkoxy group (e.g., a straight chain or branched chain C₁₋₁₀alkoxy group)), the number p may for example be selected from the rang of about 1 to 1000. When the number p is increased, the resulting three-dimensional crosslinked structure tends to be loose and deteriorate a resistance to an organic solvent. From such a viewpoint, the number p is usually about 1 to 10, preferably about 1 to 8, and more preferably about 1 to 6 (e.g., about 2 to 5).

Examples of the compound represented by the formula (III) may include the following compounds (c1) to (c3).

(c1) A compound in which the ring Het is a monocyclic or condensed cyclic aromatic heterocycle containing a 5-membered heterocycle, X is sulfur atom, oxygen atom, nitrogen atom, or imino group (NH group), r is an integer of 0 to 2 (the non-reactive group R⁵ as a substituent is absent or present), n is 0 (i.e., there is no linker L), and p is 1.

Among these compounds, the monocyclic compound having no substituent may include, for example, a 5-membered heterocyclic compound (e.g., thiophene, furan, pyrrole, imidazole, pyrazole, isothiazole, and isooxazole) and a 6-membered heterocyclic compound (e.g., triazine, pyridine, pyrazine, and pyrimidine). Examples of the condensed cyclic compound may include a compound in which the same species of heterocycles (5-membered or 6-membered heterocycles) are condensed, such as thieno[3,2-b]thiophene, dithieno[3,2-b:2',3'-d]thiophene, or naphthyridine; a compound in which different species of heterocycles (5-membered or 6-membered heterocycles) are condensed, such as thieno[2,3-b]furan; and a compound in which a benzene ring and a heterocycle are condensed, such as isobenzofuran, isoindole, isoquinoline, or phthalazine.

Among the monocyclic compounds, each having the non-reactive group R⁵, the thiophene derivative may include, for example, a 3-halothiophene (e.g., 3-chlorothiophene and 3-bromothiophene), a 3,4-dihalothiophene (e.g., 3,4-dichlorothiophene and 3,4-dibromothiophene), a 3-alkylthiophene (e.g., a 3-C₁₋₁₂alkylthiophene such as 3-methylthiophene, 3-ethylthiophene, 3-propylthiophene, 3-butylthiophene, 3-hexylthiophene, 3-octylthiophene, 3-(2-ethylhexyl)thiophene, or 3-decylthiophene), a 3,4-dialkylthiophene (e.g., a 3,4-diC₁₋₁₀alkylthiophene such as 3,4-dimethylthiophene, 3,4-diethylthiophene, or 3,4-dibutylthiophene), 3-hydroxythiophene, a 3-alkoxythiophene (e.g., a 3-C₁₋₁₂alkoxythiophene such as 3-methoxythiophene, 3-ethoxythiophene, 3-butoxythiophene, 3-hexyloxythiophene, 3-heptyloxythiophene, 3-octyloxythiophene, or 3-decyloxythiophene), a 3-arylthiophene (e.g., 3-phenylthiophene), 3-carboxythiophene, a 3-alkoxycarbonylthiophene (e.g., a 3-C₁₋₆alkoxy-carbonylthiophene such as 3-methoxycarbonylthiopheneor3-ethoxycarbonylthiophene), 3-cyanothiophene, a 3-cyanoalkylthiophene (e.g., a 3-cyanoC₁₋₆alkylthiophene such as thiophene-3-acetonitrile), a 3-(hydroxyalkyl)thiophene (e.g., a 3-(hydroxyC₁₋₆alkyl)thiophene such as 3-hydroxymethylthiopheneor3-(2-hydroxyethyl)thiophene), 3-thiophenemalonic acid, 3-thienylboronic acid, and 2-(3-thienyl)-1,3-dioxolane.

As the condensed cyclic thiophene derivative, for example, there may be mentioned thieno[3,2-b]thiophene, dithienothiophene, a halodithienothiophene (e.g., 3,5-dibromodithieno[3,2-b:2',3'-d]thiophene), and an alkyldithienothiophene (e.g., 3,5-diC₁₋₁₀alkyldithieno[3,2-b:2',3'-d]thiophene).

Examples of the furan derivative may include a halofuran (e.g., 3-chlorofuran and 3-bromofuran), a 3-alkylfuran (e.g., a 3-C₁₋₁₀alkylfuran such as 3-methylfuran), a 3-hydroxyalkylfuran (e.g., a 3-(hydroxyl-C₁₋₆alkyl)furan such as 3-furanmethanol), and 3-furylboronic acid.

The pyrrole derivative may include, for example, a 3-alkylpyrrole (e.g., a 3-C₁₋₁₀alkylpyrrole such as 3-methylpyrrole, 3-ethylpyrrole, 3-n-propylpyrrole, 3-butylpyrrole, 3-octylpyrrole, 3-decylpyrrole, or 3-dodecylpyrrole), a 3,4-dialkylpyrrole (e.g., a 3,4-diC₁₋₁₀alkylpyrrole such as 3,4-dimethylpyrrole or 3,4-dibutylpyrrole), an N-alkylpyrrole (e.g., an N-C₁₋₁₀alkylpyrrole such as N-methylpyrrole), 3-carboxypyrrole, a 3-alkoxycarbonylpyrrole (e.g., a 3-C₁₋₆alkoxy-carbonylpyrrole such as 3-ethoxycarbonylpyrrole), 3-hydroxypyrrole, and a 3-alkoxypyrrole (e.g., a 3-C₁₋₆alkoxypyrrole such as 3-methoxypyrrole, 3-ethoxypyrrole, or 3-butoxypyrrole).

As the heterocyclic compound having a fullerene unit, for example, there may be mentioned a compound represented by the following formula (IIIa): 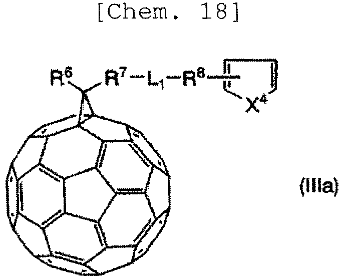 wherein R⁶ represents an alkyl group, a cycloalkyl group, or an aryl group, R⁷ and R⁸ independently represent an alkylene group, L₁ represents a linking group, and X⁴ represents a hetero atom.
The alkyl group represented by R⁶ may include the same alkyl group (a straight chain or branched chain C₁₋₁₀alkyl group) as described above; the cycloalkyl group may include the same cycloalkyl group (a C₅₋₁₀cycloalkyl group such as cyclohexyl group) as described above; the aryl group may include the same aryl group (a C₆₋₁₀aryl group such as phenyl group) as described above. As the alkylene group represented by R⁷ and R⁸, there may be mentioned a C₁₋₁₀alkylene group such as methylene group, ethylene group, propylene group, trimethylene group, or tetramethylene group. The linking group L₁ may include, for example, -C(O)O- (carbonyloxy group), -OC(O)- (oxycarbonyl group), oxygen atom, and sulfur atom. The linking group L₁ may be a direct bond (or a single bond). The hetero atom X⁴ may include sulfur atom, oxygen atom, nitrogen atom, or imino group (NH group), as described above.

The compound having the fullerene unit may be a compound in which R⁶ is phenyl group, R⁷ and R⁸ are independently a C₂₋₆alkylene group, the linking group L₁ is -C(O)O- (carbonyloxy group), and the hetero atom X⁴is sulfur atom. The compound having a fullerene unit is commercially available, for example, as [6,6]-phenyl-C61-butyric acid (3-ethylthiophene) ester.

(c2) A compound in which the ring Het represents a 5-membered or 6-membered aromatic heterocycle, X is sulfur atom, oxygen atom, nitrogen atom, or imino group (NH group), r is an integer of 0 to 2 (the non-reactive group R⁵ as a substituent is absent or present), n is 0 (i.e., there is no linker L), and p is an integer of not less than 2.

Examples of the compoundmay include a ring-assembly compound, for example, a compound represented by the following formula (IIIb):

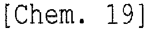

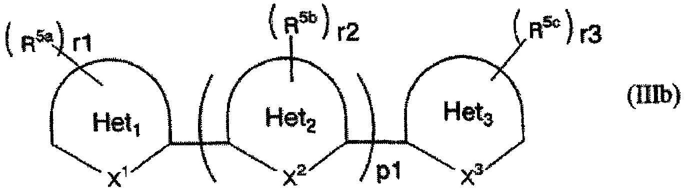

wherein the aromatic heterocycles Het₁ to Het₃ independently represent a5-membered or 6-membered aromatic heterocycle, X¹ to X³ independently represent sulfur atom, oxygen atom, nitrogen atom, or imino group (NH group), R^{5a} to R^{5c} independently represent a non-reactive group, each of r1 to r3 is an integer of 0 to 3, and p1 is an integer of 0 to 250.
The 5-membered or 6-membered aromatic heterocycle may include the monocyclic heterocycle as described in the paragraph of the aromatic heterocycle Het, for example, furan ring, thiophene ring, pyrrole ring, and pyridine ring. The preferred aromatic heterocycle includes thiophene ring, furan ring, and pyrrole ring, particularly thiophene ring.

The non-reactive groups represented by R^{5a} to R^{5c} may include the same substituents as the non-reactive group R⁵. In order to increase the solubility of the ring-assembly compound represented by the formula (IIIb), the compound preferably has the non-reactive groups R^{5a} to R^{5c}, such as an alkyl group (for example, a straight chain or branched chain C₄₋₁₀alkyl group).

Each of the number r1 to r3 can be selected from the range of 0 to 3 and is usually 0 to 2, particularly 0 or 1 in practical cases. When the ring-assembly compound represented by the formula (IIIb) has the non-reactive groups R^{5a} to R^{5c} which contribute to the improvement of the solubility, the number p1 can be selected from a wide range as described above (a range of p=1 to 1000). The number p1 can usually be selected from the range of about 0 to 250, preferably about 0 to 100 (e.g., about 1 to 75), and more preferably about 0 to 50 (e.g., about 0 to 10). When all of r1 to r3 are "0", p1 is usually about 0 to 3, preferably about 0 to 2 (for example, 1 or 2).

Examples of the compoundmay include a ring-assembly compound comprising 5-membered or 6-membered heterocycles, for example, a bifuran, a bithiophene (e.g., 2,2'-bithiophene), a terthiophene (e.g., 2,2':5',2"-terthiophene), a quaterthiophene (e.g., 2,2':5',2":5",2"'-quaterthiophene), a bipyridine (e.g., 2,2'-bipyridine), a quaterpyridine, a 3,4'-dialkyl-2,2'-bithiophene (e.g., a 3,4'-diC₄₋₁₀alkyl-2,2'-bithiophene such as 3,4'-dihexyl-2,2'-bithiophene), a poly(3-alkyl-thiophene) (such as a polythiophene compound in which X¹ to X³ are sulfur atom, the aromatic heterocycle Het₁ to Het₃ are 2,5-thiophene-diyl group, R^{5a} to R^{5c} are a C₄₋₁₀alkyl on 3-position or 4-position, each of r1 to r3 is 1, and p1 is about 1 to 25), 2, 5-di (2-thienyl) -1H-pyrrole, and 2-(3-thienyl)pyridine.

Further, the ring-assembly compound may be a compound having an arylmethylene group (or an arylvinylene group) between the heterocycles thereof. The compound may for example be represented by the following formula (IIIc) or (IIId): 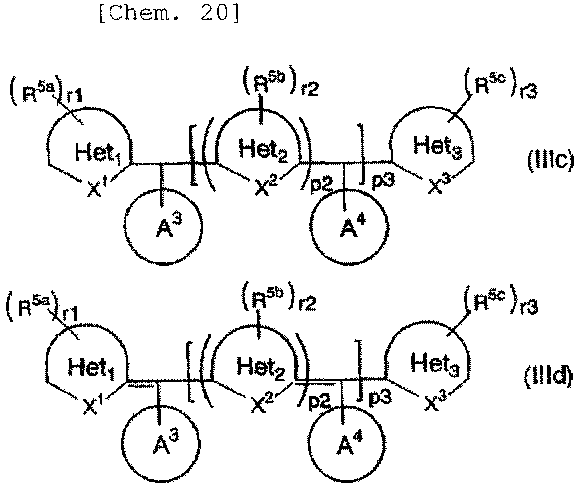 wherein A³ and A⁴ independently represent a ring having aromaticity, p2 and p3 are independently an integer of 1 to 5, and Het₁ to Het₃, X¹ to X³, R^{5a} to R^{5c}, and r1 to r3 have the same meanings as defined above.
Het₁ to Het₃ may include the same aromatic heterocycle as described above (e.g., a 5-membered aromatic heterocycle such as thiophene ring) ; X¹ to X³ may include the same hetero atom as described above (e. g. , sulfur atom); R^{5a} to R^{5c} may include the same non-reactive group as described above (e.g., a C₁₋₁₀alkyl group such as hexyl group) ; r1 to r3 may be the same integer of 0 to 3 as described above (for example, 0 or 1); A³ and A⁴ may include the same ring having aromaticity as described above (e.g., a C₆₋₁₀arene ring such as benzene ring or naphthalene ring); p2 is an integer of about 1 to 5 (e.g. , about 1 to 4, preferably about 1 to 3); and p3 is an integer of about 1 to 5 (e.g., about 1 to 4, preferably about 1 to 3).

The compound represented by the formula (IIIc) can be obtained by a reaction of the same aromatic heterocyclic compound as described above and an aromatic monoaldehyde compound (e.g., an arylaldehyde such as benzaldehyde, and a heteroarylaldehyde) to form a carbon-carbon single bond (-C-C-) at the above-mentioned α-carbon site. The compound represented by the formula (IIId) can be obtained by subjecting the compound represented by the formula (IIIc) to a dehydrogenation reaction to form a carbon-carbon double bond (-C=C-).

(c3) A compound in which the ring Het represents a 5-membered aromatic heterocycle, X is sulfur atom, oxygen atom, nitrogen atom, or imino group (NH group), r is an integer of 0 to 2 (the non-reactive group R⁵ as a substituent is absent or present), n is 1, and the linker L is vinylene group.

Examples of the compound may include 1,2-di(2-thienyl)ethylene, furil, and furoin.

These aromatic heterocyclic compounds may be used singly or in combination. The aromatic heterocyclic compoundpreferablyhas 2 to 8 (for example, 2 to 6, preferably 2 to 4, more preferably 2 to 3, and e.g., 2) reactive sites (unmodified α-carbon positions) per molecule. The aromatic heterocyclic compound is usually employed in combination with an aromatic polyaldehyde compound having a plurality of (e.g., 2 to 4, particularly 3 to 4) formyl groups per molecule. The aromatic heterocyclic compound may for example be shown in the following Table 12 to Table 16.

[Table 12]

**Table 12**

| L | n | p | r | Compound name | Structural formula |
|---|---|---|---|---|---|
| - | 0 | 1 | 0 | Thiophene | 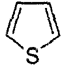 |
| - | 0 | 1 | 1 | 3-Alkylthiophene | 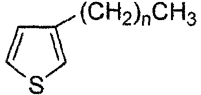 |
| - | 0 | 1 | 1 | 3-Methoxythiophene | 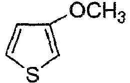 |
| - | 0 | 1 | 1 | 3-Phenylthiophene | 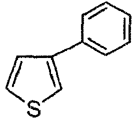 |
| - | 0 | 1 | 1 | 3-(Hydroxyalkyl)thiophene | 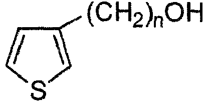 |
| - | 0 | 1 | 1 | Thiophene-3-acetonitrile | 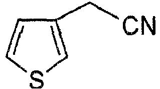 |

[Table 13]

**Table 13**

| L | n | p | r | Compound name | Structural formula |
|---|---|---|---|---|---|
| - | 0 | 1 | 1 | 3-Thiophenemalonic acid | 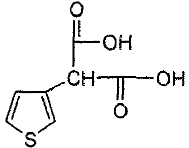 |
| - | 0 | 1 | 1 | 3-Thienylboronic acid | 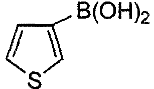 |
| - | 0 | 1 | 0 | Thieno[3,2-b]thiophene | 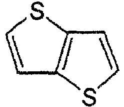 |
| - | 0 | 1 | 2 | 3,6-Dibromothieno[3,2-b]thiophene | 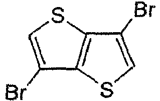 |
| - | 0 | 1 | 0 | Dithienothiophene | 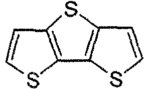 |
| - | 0 | 1 | 2 | 3,5-Dibromodithieno[3,2-b:2',3'-d]thiophene | 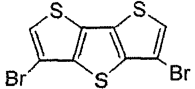 |

[Table 14]

**Table 14**

| L | n | p | r | Compound name | Structural formula |
|---|---|---|---|---|---|
| - | 0 | | 0 | Oligo- or polythiophene | 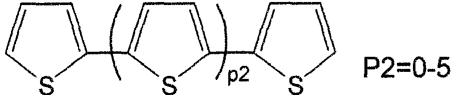 |
| - | 0 | | 1 | Oligo- or poly(3-hexylthiophene) | 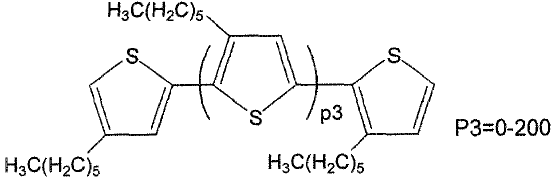 |
| - | 0 | 2 | 1 | 3,4'-Dihexyl-2,2'-bithiophene | 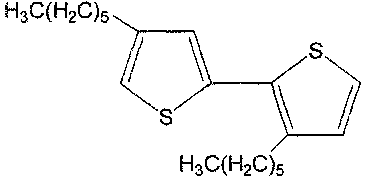 |
| - | 0 | 3 | 0 | 2,2':5',2'-Terthiophene | 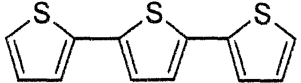 |
| - | 0 | 3 | 0 | 2,5-Di(2-thienyl)-1H-pyrrole | 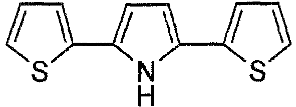 |

[Table 15]

**Table 15**

| L | n | p | r | Compound name | Structural formula |
|---|---|---|---|---|---|
| - | 0 | 2 | 0 | 2-(3-Thienyl)pyridine | 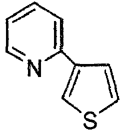 |
| - | 0 | 1 | 1 | 2-(3-thienyl)-1,3-dioxolane | 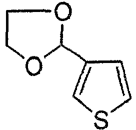 |
| Vinylene group | 1 | 2 | 0 | 1,2-Di(2-thienyl)ethylene | 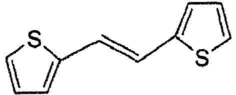 |
| - | 0 | 1 | 0 | Furan | 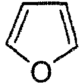 |
| - | 0 | 1 | 1 | 3-Bromofuran | 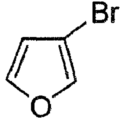 |
| - | 0 | 1 | 1 | 3-Methylfuran | 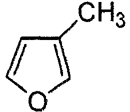 |

[Table 16]

**Table 16**

| L | n | p | r | Compound name | Structural formula |
|---|---|---|---|---|---|
| - | 0 | 1 | 1 | Ethyl 3-furancarbonate | 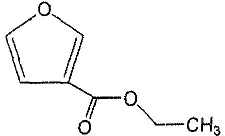 |
| - | 0 | 1 | 1 | 3-Furanmethanol | 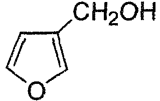 |
| - | 0 | 1 | 1 | 3-Furylboronic acid | 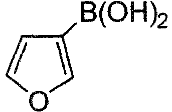 |
| - | 0 | 1 | 0 | Pyrrole | 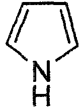 |
| - | 0 | 1 | 1 | 3-Methylpyrrole | 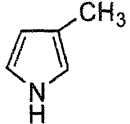 |

The aromatic heterocyclic compound has a plurality of unmodified α-carbon positions, each adjacent to a hetero atom of a heterocycle thereof, and the number of α-carbon positions per molecule is about 2 to 5, preferably about 2 to 4, and particularly about 2 or 3. The α-carbon sites, each adjacent to the hetero atom, are usually 2, 5-positions in a monocyclic 5-membered heterocycle, or 2,6-positions in a monocyclic 6-membered heterocycle. Moreover, in a heterocycle having a condensed 5-membered heterocycle (for example, thieno[3,2-b]thiophene and dithieno [3,2-b:2',3'-d] thiophene), the α-carbon sites are located in 2-position and/or 5-position; in a heterocyclic compound having a condensed 6-membered heterocycle, the α-carbon sites are located in 2-position and/or 6-position. A heterocyclic compound having two α-carbon sites in the molecule is used in combination with an aromatic aldehyde compound having formyl groups of not less than 3 permolecule.

The ratio of the aromatic polyaldehyde compound relative to the aromatic heterocyclic compound may for example be about 70/30 to 30/70, preferably about 60/40 to 40/60, and more preferably about 55/45 to 45/55 in a ratio of the former/the latter in terms of equivalent ratio of formyl group relative to free (or unsubstituted) α-carbon site in the heterocyclic compound.

### (Aromatic polyamine and aromatic heterocyclic compound)

The aromatic polyaldehyde compound may be used in combination with an aromatic reactive component comprising both aromatic polyamine and aromatic heterocyclic compound. The ratio of the aromatic polyamine relative to the aromatic heterocyclic compound may for example be about 70/30 to 30/70, preferably about 60/40 to 40/60, and more preferably about 55/45 to 45/55 in a ratio of the former/the later in terms of the equivalent ratio of the reactive sites. The ratio of the aromatic polyaldehyde compound relative to the aromatic reactive component is the same as the above-mentioned ratio of the aromatic polyaldehyde compound relative to the aromatic polyamine or the aromatic heterocyclic compound.

### (Acid catalyst)

The composition comprising the aromatic polyaldehyde compound and the aromatic heterocyclic compound preferably contains an acid catalyst. When the aromatic heterocyclic compound contains an acidic group such as sulfo group or dihydroxybornyl group (-B(OH)₂), the acid catalyst is not necessarily needed. The acid catalyst may be either a protonic acid or a Lewis acid. The protonic acid may include, for example, an inorganic acid (e.g., hydrochloric acid, hydrobromic acid, sulfuric acid, phosphoric acid, perchloric acid, and hydrofluoric acid) and an organic acid (e.g. , an organic carboxylic acid such as acetic acid, propionic acid, trichloroacetic acid, or trifluoroacetic acid, and a sulfonic acid such as methanesulfonic acid, ethanesulfonic acid, trifluoromethanesulfonic acid, p-toluenesulfonic acid, or styrenesulfonic acid). Examples of the Lewis acid may include aluminum chloride, tin chloride, zinc chloride, titanium chloride, boron fluoride, and boron fluoride ether complex salt. These acid catalysts may be used singly or in combination.

The amount of the acid catalyst may be selected from the range of, for example, about 0.001 to 1 parts by weight (e.g., about 0.01 to 1 parts by weight) relative to 1 part by weight of the total amount of the aromatic polyaldehyde compound and the aromatic heterocyclic compound, and may usually be about 0.005 to 0.3 parts by weight, preferably about 0.01 to 0.2 parts by weight, and more preferably about 0.02 to 0.1 parts by weight.

### (Organic solvent)

The composition of the present inventionmay further comprise an organic solvent (or a solvent). Since the organic solvent can improve a coating property of the composition, the solvent can be used as an component of a coating composition. The organic solvent is not particularly limited to a specific one as far as the aromatic polycarbonyl compound and the aromatic polyamine and/or the aromatic heterocyclic compound can be dissolved in the solvent and the solvent does not inhibit the reaction. For example, the organic solvent may include an amide (for example, formamide; an N-mono- or diC₁₋₄alkylformamide such as N-methylformamide or N,N-dimethylformamide; and an N-mono- or diC₁₋₄alkylacetamide such as N-methylacetamide or N,N-dimethylacetamide), a hydrocarbon (for example, an aromatic hydrocarbon such as toluene or xylene), a halogenated hydrocarbon (e.g., dichloromethane, chloroform, and chlorobenzene), a ketone (e.g., acetone and methyl ethyl ketone), an ester (e.g., methyl acetate, ethyl acetate, and butyl acetate), a nitrile (e.g., acetonitrile and propionitrile), a sulfoxide (e.g., dimethylsulfoxide), an ether (e.g., a chain ether such as dimethyl ether or diethyl ether, and a cyclic ether such as dioxane or tetrahydrofuran), a pyrrolidone (e.g., 2-pyrrolidone, 3-pyrrolidone, N-methyl-2-pyrrolidone, and N-methyl-3-pyrrolidone), a carbitol (e.g., a C₁₋₄alkylcarbitol such as methylcarbitol, ethylcarbitol, propylcarbitol,or butylcarbitol). These organic solvents may be used alone or in combination. Among these organic solvents, an amide, for example, an N,N-diC₁₋₄alkylacetamide such as N,N-dimethylacetamide is preferred.

The ratio of the organic solvent relative to 1 part by weight of the total of the aromatic polycarbonyl compound and the aromatic polyamine and/or the aromatic heterocyclic compound can be selected from the range of about 0.1 to 200 parts by weight (e.g., about 1 to 200 parts by weight, preferably about 1 to 100 parts by weight, and more preferably about 1 to 50 parts by weight), and may for example be about 1 to 40 parts by weight (e.g., about 1 to 35 parts by weight), preferably about 3 to 20 parts by weight, and more preferably about 5 to 10 parts by weight.

The composition of the present invention can be prepared by a conventional method, for example, by mixing the aromatic polycarbonyl compound and the aromatic polyamine and/or the aromatic heterocyclic compound. In particularly, the composition (coating composition) containing the organic solvent (solvent) may be prepared by dissolving the aromatic polycarbonyl compound and the aromatic polyamine and/or the aromatic heterocyclic compound in the organic solvent (solvent) and optionally filtering the resulting mixture.

### [Organic semiconductor]

The chemical structure of the organic semiconductor of the present invention (or organic semiconductor film or layer) obtainable from the composition comprising the aromatic polycarbonyl compound and the aromatic polyamine is not particularly limited to a specific one, and usually has a structure in which a unit derived from the aromatic polycarbonyl compound and a unit derived from the aromatic polyamine are joined through a π-conjugated system unit [for example, a carbon-nitrogen double bond (-C=N-), a carbon-carbon double bond (-C=C-), a carbon-carbon triple bond (-C≡C-), an amide bond (-NHCO-), an imidazole ring, an oxazole ring, and a thiazole ring]. The π-conjugated system unit is preferably at least one unit selected from the group consisting of a carbon-nitrogen double bond (-C=N-), an imidazole ring, an oxazole ring, and a thiazole ring.

The organic semiconductor of the present invention usually contains a unit (a repeating unit or a crosslinking unit) represented by the following formula (IV-1) or (IV-2) : 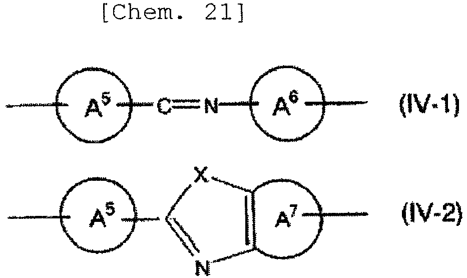 wherein A⁵, A⁶, and A⁷ each represent a ring having aromaticity (or an aromatic ring) or a ring-assembly, X represents nitrogen atom, oxygen atom, or sulfur atom.
The ring having aromaticity represented by A⁵ (a ring having aromaticity derived from the aromatic polycarbonyl compound), and the ring having aromaticity represented by A⁶ and A⁷ (a ring having aromaticity derived from the aromatic polyamine) may include the same ring as the ring A. The preferred ring A⁵ is the aromatic ring as the ring A¹. The preferred ring A⁶ or A⁷ is the same aromatic ring as the ring A².

In the formula (IV-1) or (IV-2), for expedience, the ring A⁵ has one bonding site extending outward, and the ring A⁶ and/or the ring A⁷ has one bonding site extending outward. At least one ring selected from the ring A⁵ and the ring A⁶ or the ring A⁷ has a plurality of bonding sites to form a three-dimensional crosslinked structure.

The organic semiconductor of the present invention obtainable from the composition comprising the aromatic polyaldehyde compound and the aromatic heterocyclic compound usually contains a unit (a repeating unit or a crosslinking unit) represented by the following formula (IV-3) or (IV-4). The preferred repeating unit or crosslinking unit contains at least a unit represented by the formula (IV-4): 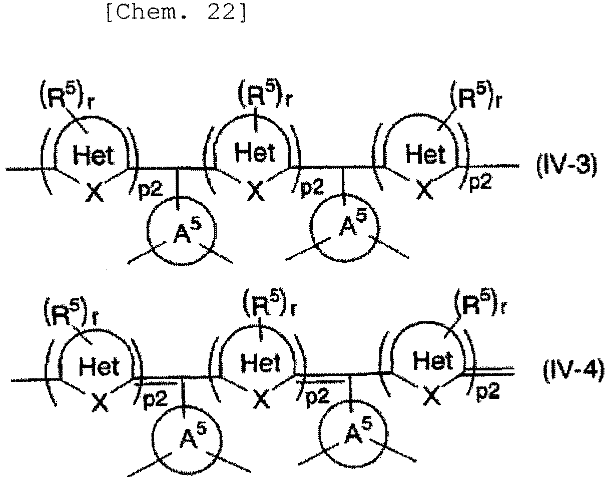 wherein A⁵, Het, X, R⁵, r, and p2 have the same meanings as defined above.
Examples of the ring having aromaticity A⁵ (ring having aromaticity derived from the aromatic polycarbonyl compound) may include the same ring as the ring A (the same aromatic ring as the ring A¹). The aromatic heterocycle represented by Het may include the same aromatic heterocycle as the heterocycle Het (a monocyclic, condensed cyclic or ring-assembly heterocycle containing a 5-membered ring in which X is sulfur atom, oxygen atom, or nitrogen atom).

In the same manner as the relation between the compound represented by (IIIc) and the compound represented by (IIId), the compound represented by the formula (IV-4) can be obtained by subjecting the compound represented by the formula (IV-3) to dehydrogenation reaction.

Moreover, since the reaction (thermal polymerization) between the carbonyl-containing group and the amino group and the reaction between the formyl group and the α-carbon site of the heterocyclic compound easily proceed, it is presumed that the organic semiconductor of the present invention is formed as one polymer coupled in three-dimensional network structure. When the organic semiconductor is formed with/as one polymer, the organic semiconductor substantially does not produce the intermolecular electron transfer (hopping) and has an extremely high electron mobility.

The physical structure of the organic semiconductor of the present invention is usually a three-dimensional network structure (a crosslinked structure). It can be determined based on the solubility in the organic solvent or the band gap whether the organic semiconductor has a three-dimensional network structure or not. Specifically, the organic semiconductor of the present invention is insoluble or sparingly soluble in an organic solvent (for example, an N,N-diC₁₋₄alkylacetamide such as N,N-dimethylacetamide) and has a band gap smaller than a band gap of a polymerizable component (or a reactive component) in many cases, and it is presumed that the organic semiconductor has a three-dimensional network structure.

Although the details of the three-dimensional network structure is not known, the structure may be a graphite-like structure. The change of the spread of the π-conjugated system by the molecular vibration of the monomer unit due to heat allows rapid and stable electron transfer.

The thickness of the organic semiconductor is suitably selected according to use, and may for example be about 1 to 5000 nm, preferably about 30 to 1000 nm, and more preferably about 50 to 500 nm.

The organic semiconductor of the present invention may be a n-type semiconductor, a p-type semiconductor, or an intrinsic semiconductor. Whether the organic semiconductor is categorized into an intrinsic semiconductor or not can be determined on the basis that the organic semiconductor has rectification characteristics obtained even formed into either a p-type semiconductor or an n-type semiconductor.

The organic semiconductor may comprise a cured product (a crosslinked product) of the composition, and can be, for example, produced by polymerizing the composition. Specifically, the organic semiconductor may be produced by a step for laminating or applying the composition to a substrate (such as a glass plate, a silicon wafer, or a heat-resisting plastic film) and a step for heat-treating the composition for polymerization. If necessary, the organic semiconductor may be separated (or released) from the substrate.

The method for laminating or applying the composition may include, for example, a deposition method such as chemical vapor deposition (e.g., CVD) and an applying (or coating) method. Among these laminating methods, the applying or coating method is preferred from the viewpoint of the coordination of the species or proportion of the polymerizable component (or the reactive component) with a high accuracy to easily control the properties of the organic semiconductor.

The applying method may include a conventional manner, for example, an air knife coating, a roll coating, a gravure coating, a blade coating, a dip coating, a spraying, a spin coating, and an ink jet printing. After applying, the resulting coated layer is usually dried to remove the solvent therefrom.

The polymerization step may be carried out under an inert gas atmosphere (e.g., nitrogen). Moreover, the heat treatment temperature may for example be about 50 to 500°C (e.g., about 150 to 500°C), preferably about 100 to 400°C (e.g., about 200 to 400°C), and more preferably about 150 to 300°C or about 250 to 350°C. The heat treatment time may for example be about 0.1 to 2.5 hours, preferably about 0.2 to 2.0 hours, and more preferably about 0.3 to 1. 5 hours.

In the reaction of the aromatic polyaldehyde compound with the aromatic heterocyclic compound, the unit (or crosslinking unit) represented by the formula (IV-3) is produced as described above, and the unit represented by the formula (IV-3) can be converted into the unit (or crosslinking unit) represented by the formula (IV-4) by dehydrogenation reaction. As the dehydrogenation reaction, although there may be used a photodehydrogenation which comprises irradiating with an active light (such as a mercury lamp or a xenon lamp) or other methods, a thermal dehydrogenation (for example, a treatment at the heat treatment temperature) is practically used. Use of the composition containing the acid catalyst allows the dehydrogenation reaction to be easily conducted.

The organic semiconductor has excellent heat resistance, solvent resistance, and durability. Specifically, the organic semiconductor inhibits the change of film quality (crystallization) and prevents shortening of the lifetime of a device even if an external energy is applied. Moreover, the performance of the semiconductor can be recovered by heating and evaporating water entering from the outside. Further, a coating composition containing an organic solvent can directly be applied to the organic semiconductor to form a laminated structure easily.

### [Organic-inorganic hybrid semiconductor]

According to the present invention, an organic-inorganic hybrid semiconductor may be formed by laminating or stacking the organic semiconductor on at least part of an inorganic semiconductor (for example, in the case of a sheet, at least one side of an inorganic semiconductor). Since the organic semiconductor of the present invention has a pseudo or quasi band structure as a whole and can be handled in the same manner as an inorganic semiconductor, a hybridization or composition of the organic semiconductor with an inorganic semiconductor can easily be achieved. Since the high carrier transfer of the inorganic semiconductor, for example, can increase the mobility of electrons and holes generated by light absorption and improve the photoelectric conversion efficiency, the hybrid semiconductor is suitably applied for a photoelectric conversion device (e.g., a solar cell) .

The material for the inorganic semiconductor is not particularly limited to a specific one and may be a known material [for example, at least one metal selected from the group consisting of the groups 2B (such as zinc), 3B (such as aluminum or indium), and 4B (such as silicon or tin) elements of the Periodic Table, or an oxide thereof]

The thickness of the inorganic semiconductor is suitably selected according to the production process and application, and may be about 1 nm to 1 mm.

The lamination structure of the organic-inorganic hybrid semiconductor is not particularly limited to a specific lamination order, depending on a laminated structure thereof. The organic-inorganic hybrid semiconductor may be produced by applying the coating composition to at least one side of an inorganic semiconductor and then heat-treating the coated layer. The inorganic semiconductor may be produced by depositing a construction material on a substrate using a conventional method [e.g., a physical vapor deposition (PVD) such as vacuum evaporation, sputtering, or ion plating, and a chemical vapor deposition (CVD) such as plasma CVD].

### [Device]

The device (electronic device) of the present invention is provided with (or comprises) the semiconductor (such as an organic semiconductor or an organic-inorganic hybrid semiconductor). The device may include a rectifier (a diode), a transistor [e.g., a top-gate transistor and a bottom-gate transistor (a top-contact transistor, a bottom-contact transistor)], and a photoelectric conversion element (e. g., a solar cell device and an organic EL device).

As a representative device, the solar cell has a structure having a pn-junction semiconductor and a surface electrode laminated (or formed) thereon. For example, the solar cell can be formed by laminating an organic semiconductor layer (or film) on a p-type silicon semiconductor and laminating (or forming) a transparent electrode (such as an ITO electrode) on the organic semiconductor layer (or film). The solar cell can achieve a high open-circuit voltage as well as a short-circuit current.

The organic EL device has a laminated structure which comprises, in sequence, a transparent electrode (such as an ITO electrode), a hole-transporting layer, an electron-transporting layer (such as an aluminum-quinolinol complex layer or a beryllium-benzoquinolinol complex layer), and a metal electrode. For example, an organic EL device can be formed by laminating an organic semiconductor layer (or film), an electron-transporting layer, and a metal electrode in sequence on a transparent electrode. In this case, the organic semiconductor layer (or film) functions as a hole-transporting layer.

The organic thin-film transistor comprises a gate electrode layer, a gate insulating layer, a source/drain electrode layer, and an organic semiconductor layer. Depending on the laminated structure composed of these layers, the organic thin-film transistor can be classified into a top-gate transistor and a bottom-gate transistor (a top-contact transistor, a bottom-contact transistor). For example, a top-contact field effect transistor can be produced by forming an organic semiconductor layer (or film) on a gate electrode (e.g., a p-type silicon wafer having an oxide layer formed thereon) and forming a source-drain electrode (a gold electrode) on the organic semiconductor layer (or film).

### EXAMPLES

The following examples are intended to describe this invention in further detail and should by no means be interpreted as defining the scope of the invention.

### Example 1

### (1) Preparation of composition (coating composition)

In a 6-ml sample bottle, 16.2 mg of 1,3,5-triformylbenzene (manufactured by NARD INSTITUTE, LTD.) and 29.0 mg of tris (4-aminophenyl) amine were added, and these compounds were dissolved in 860 mg of N,N-dimethylacetamide. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 300°C for 1 hour under a nitrogen atmosphere to give an organic semiconductor layer (hereinafter, referred to as BTA-TAPA).

### (3) Structure of organic semiconductor layer

### (3-1) Solubility in organic solvent

A silicon wafer (or glass plate) was used as a substrate, and a BTA-TAPA layer was produced according to the method of the step (2). The resulting layer was insoluble in N,N-dimethylacetamide and proved to have a three-dimensional network structure.

### (3-2) Band gap

A glass plate was used as a substrate, and a BTA-TAPA layer was produced according to the method of the step (2). The UV-Vis spectrum of the BTA-TAPA layer was measured (by "Spectrophotometer U-3900H" manufactured by Hitachi High-Technologies Corporation) to determine a band gap from the absorption edge. As comparison, the band gap of 1,3,5-triformylbenzene and that of tris(4-aminophenyl)amine were determined. The results revealed that the band gap of the BTA-TAPA layer was smaller than those of the composition components. Thus the resulting BTA-TAPA layer proved to have a structure having a more extended conjugated system by the crosslinking reaction.

### (3-3) Measurements of HOMO and LUMO values

According to the method of the step (2), a platinum plate was coated with a BTA-TAPA layer. Using the platinum plate as a working electrode, the oxidation-reduction potential (HOMO value) was measured by cyclic voltammetry (manufactured by BAS Inc., "ALS600A"). The resulting oxidation-reduction potential (HOMO value) was 5.2 eV. The band gap value was subtracted from the resulting value to calculate the LUMO value. The resulting LUMO value was 2.5 eV.

### (4) Evaluation of electric properties (diode properties)

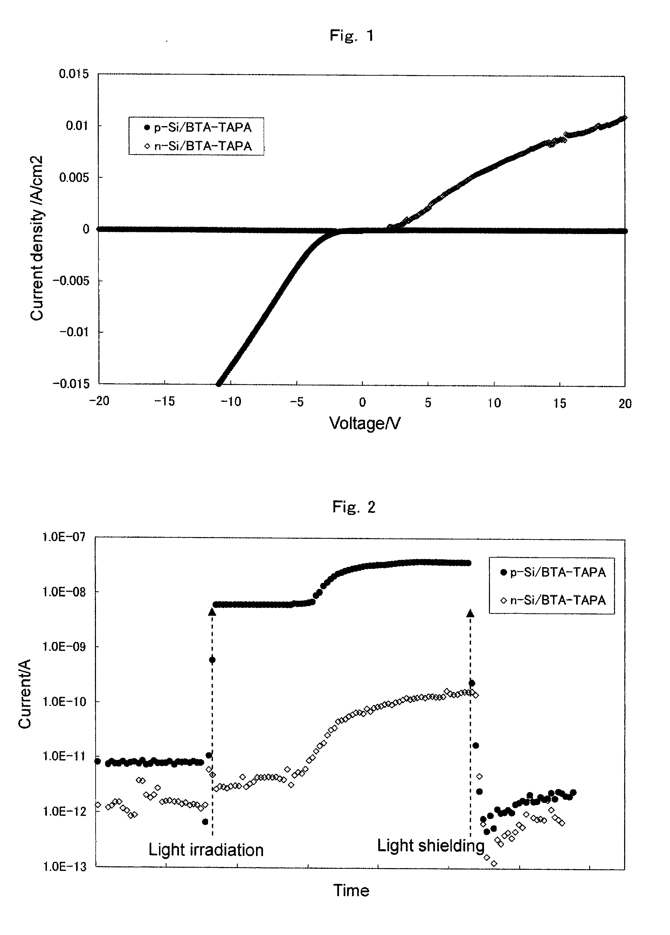

Using p-type and n-type silicon wafers as substrates, a BTA-TAPA layer was formed on each substrate according to the method of the step (2). Then an aluminum electrode having a diameter of 1 mm and a thickness of 700 nm was formed on each BTA-TAPA layer by vacuum evaporation to give a pn-junction rectifier. The rectification was measured by applying a voltage on these rectifiers. The results provided clear rectification properties as shown in Fig. 1. Thus, the produced BTA-TAPA layer proved to be an intrinsic semiconductor having both p-type and n-type properties.

### (5) Photoelectric conversion evaluation

Using p-type and n-type silicon wafers as substrates, a BTA-TAPA layer having a thickness of 50 nm was formed on each substrate according to the method of the step (2). An ITO layer was formed on each BTA-TAPA layer by sputtering to give a photoelectric conversion element. The light response properties of these elements are shown in Fig. 2. The open-circuit voltage and the short-circuit current measured were 0.3 V and 100 µA/cm², respectively, in combination with the p-type silicon, and 0.05 V and 0.1 µA/cm², respectively, in combination with the n-type silicon.

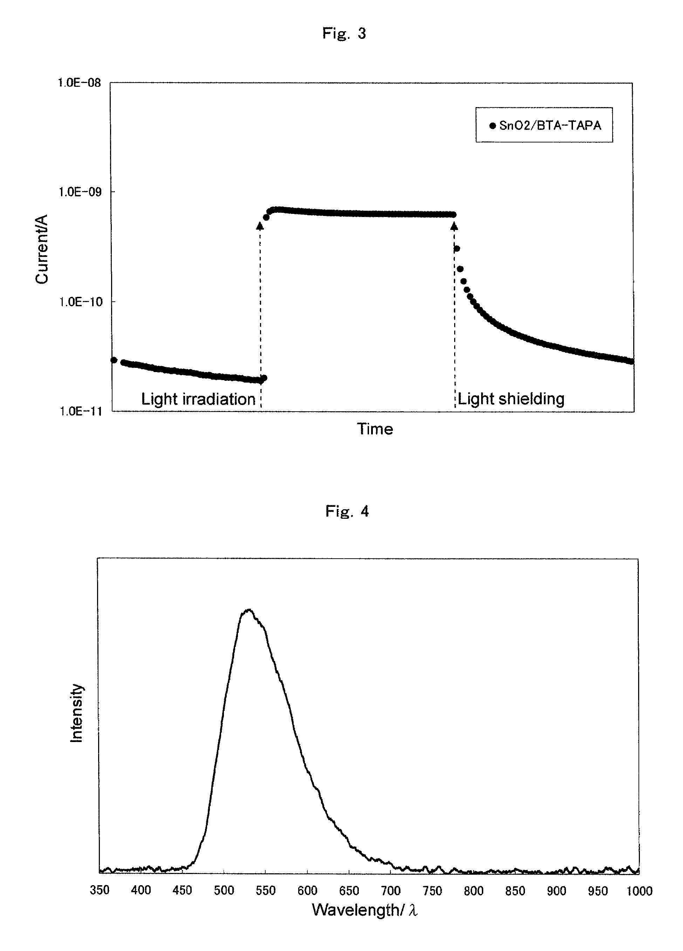

Moreover, a photoelectric conversion element was produced in the same manner as in the above method except that SnO₂ was used as the inorganic semiconductor. The light response properties of the element are shown in Fig. 3. The open-circuit voltage and the short-circuit current measured were 0.7 V and 1.0 µA/cm², respectively.

### (6) Organic EL device

A glass plate having an ITO layer formed thereon was subjected to ultrasonic cleaning in acetone, and then the surface of the ITO was washed by ozone irradiation. According to the method of the step (2), a BTA-TAPA layer having a thickness of 30 nm was formed on the ITO layer. The resulting product was set in a vacuum evaporation apparatus (manufactured by ULVAC, Inc., "VPC-410"), and a tris(8-hydroxyquinolinato)aluminum (hereinafter, sometimes referred to as "Alq3") layer having a thickness of 30 nm was formed on the BTA-TAPA layer by deposition. Further, a lithium-aluminum alloy (lithium content: 0.5% by weight) layer having a thickness of 300 nm was formed thereon by deposition to produce an organic EL device. The introduction of electric current to the organic EL device provided green luminescence derived from Alq3 as Fig. 4. This proved that the BTA-TAPA layer functioned as a hole-transporting layer.

### Example 2

### (1) Preparation of composition (coating composition)

In a 6-ml sample bottle, 16.2 mg of 1,3,5-triformylbenzene (manufactured by NARD INSTITUTE, LTD.) and 29.4 mg of 2,7-diaminofluorene were added, and these compounds were dissolved in 1400 mg of N,N-dimethylacetamide. This mixture was filtered through a filter having a pore size of 0.2 µm to prepare a composition (a coating composition).

### (2) Production of organic semiconductor layer

Using the composition obtained in the above step (1), an organic semiconductor layer (hereinafter, referred to as BTA-DAF) was obtained in the same manner as in Example 1.

### (3) Structure of organic semiconductor layer

### (3-1) Solubility in organic solvent

A BTA-DAF layer was produced in the same manner as in Example 1. The resulting layer was insoluble in N,N-dimethylacetamide and proved to have a three-dimensional network structure.

### (3-2) Band gap

The UV-Vis spectrum of the BTA-DAF layer was measured in the same manner as in Example 1 to determine a band gap from the absorption edge.

### (3-3) Measurements of HOMO and LUMO values

The oxidation-reduction potential (HOMO value) of the BTA-DAF layer measured in the same manner as in Example 1 was 5.4 eV. The band gap value was subtracted from the resulting value to calculate the LUMO value. The resulting LUMO value was 2.7 eV.

### (4) Evaluation of electric properties (diode properties)

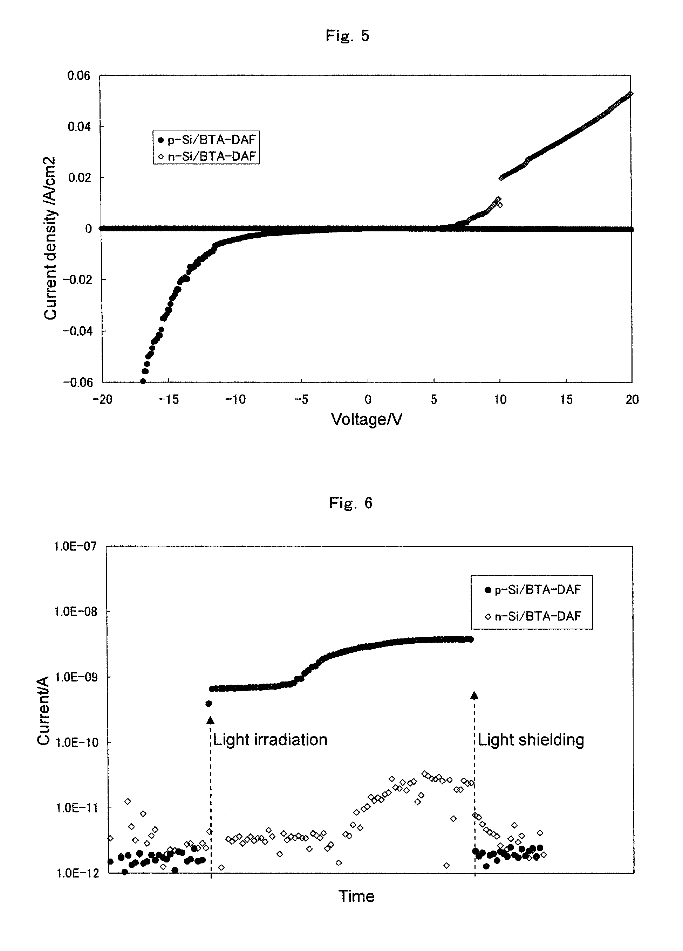

Two pn-junction rectifiers, each composed of silicon and the BTA-DAF layer, were obtained in the same manner as in Example 1. The rectification was measured by applying a voltage on these rectifiers. The results provided clear rectification properties as shown in Fig. 5. Thus, the produced BTA-DAF layer proved to be an intrinsic semiconductor having both p-type and n-type properties.

### (5) Photoelectric conversion evaluation

Two photoelectric conversion elements, each composed of silicon and the BTA-DAF layer, were produced in the same manner as in Example 1. The light response properties of these elements are shown in Fig. 6. The open-circuit voltage and the short-circuit current measured were 0.2 V and 10 µA/cm², respectively, in combination with the p-type silicon, and 0.02 V and 0.05 µA/cm², respectively, in combination with the n-type silicon.

### Example 3

### (1) Preparation of composition (coating composition)

In a 6-ml sample bottle, 16.2 mg of 1,3,5-triformylbenzene (manufactured by NARD INSTITUTE, LTD.) and 34.8 mg of 1, 3-diaminopyrene were added, and these compounds were dissolved in 1650mgofN, N-dimethylacetamide. This mixture was filtered through a filter having a pore size of 0.2 µm to prepare a composition (a coating composition).

### (2) Production of organic semiconductor layer

Using the composition obtained in the above step (1), an organic semiconductor layer (hereinafter, referred to as BTA-13DAPy) was obtained in the same manner as in Example 1.

### (3) Structure of organic semiconductor layer

### (3-1) Solubility in organic solvent

A BTA-13DAPy layer was produced in the same manner as in Example 1. The resulting layer was insoluble in N,N-dimethylacetamide and proved to have a three-dimensional network structure.

### (3-2) Band gap

The UV-Vis spectrum of the BTA-13DAPy layer was measured in the same manner as in Example 1 to determine a band gap from the absorption edge.

### (3-3) Measurements of HOMO and LUMO values

The oxidation-reduction potential (HOMO value) of the BTA-13DAPy layer measured in the same manner as in Example 1 was 5.6 eV. The band gap value was subtracted from the resulting value to calculate the LUMO value. The resulting LUMO value was 3.3 eV.

### (4) Evaluation of electric properties (diode properties)

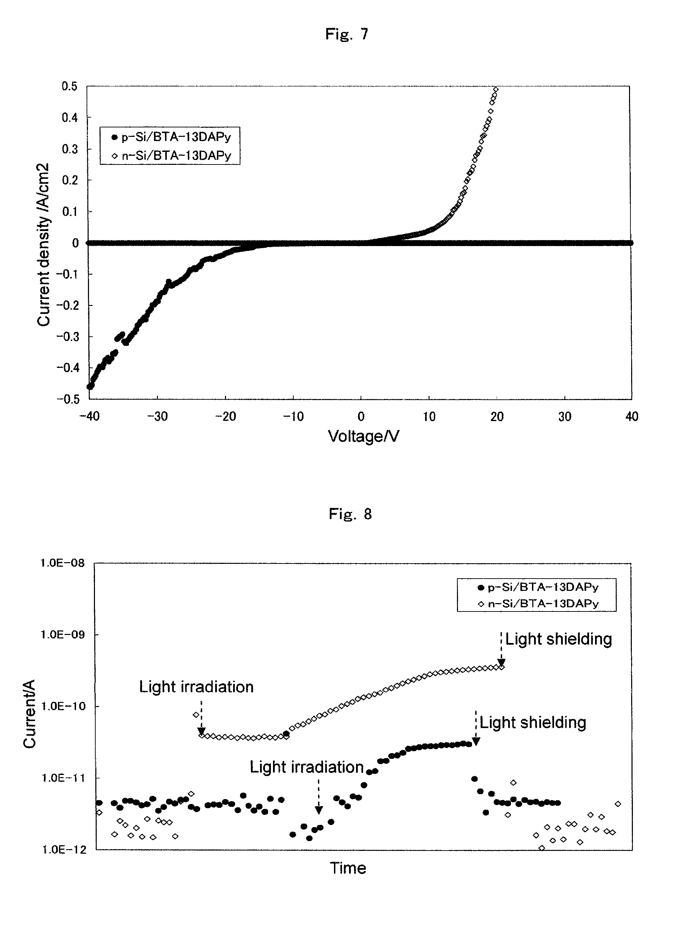

Two pn-junction rectifiers, each composed of silicon and the BTA-13DAPy layer, were obtained in the same manner as in Example 1. The rectification was measured by applying a voltage on these rectifiers. The results provided clear rectification properties as shown in Fig. 7. Thus, the produced BTA-13DAPy layer proved to be an intrinsic semiconductor having both p-type and n-type properties.

### (5) Photoelectric conversion evaluation

Two photoelectric conversion elements, each composed of silicon and the BTA-13DAPy layer, were produced in the same manner as in Example 1. The light response properties of these elements are shown in Fig. 8. The open-circuit voltage and the short-circuit current measured were 0.2 V and 10 µA/cm², respectively, in combination with the p-type silicon, and 0.1V and 0.05 µA/cm², respectively, in combination with the n-type silicon.

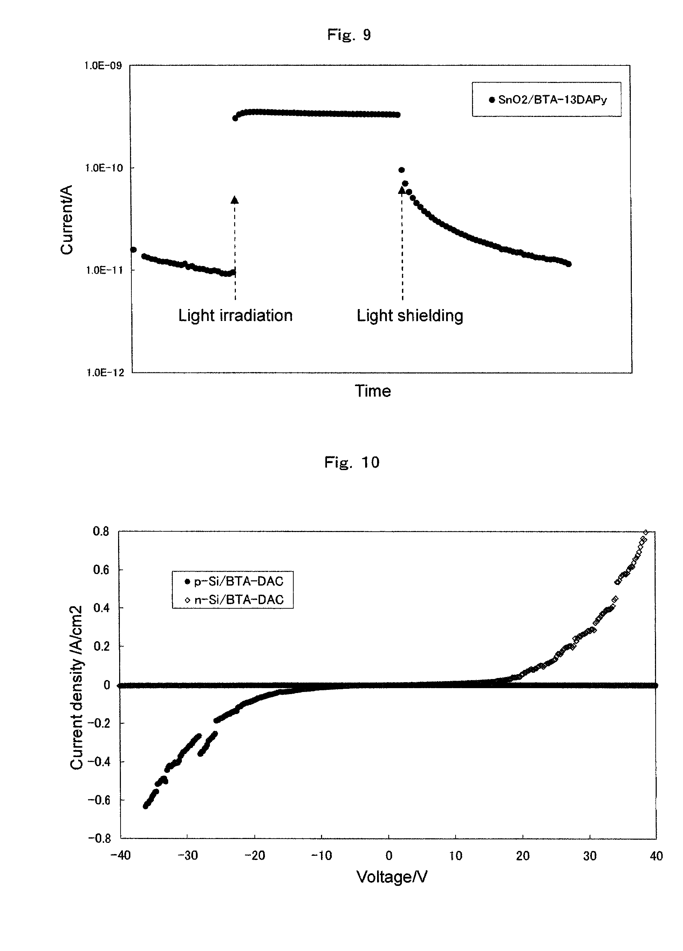

Moreover, a photoelectric conversion element was produced in the same manner as in the above method except that SnO₂ was used as the inorganic semiconductor. The light response properties of the element are shown in Fig. 9. The open-circuit voltage and the short-circuit current measured were 0.67 V and 0.6 µA/cm², respectively.

### Example 4

### (1) Preparation of composition (coating composition)

In a 6-ml sample bottle, 16.2 mg of 1,3,5-triformylbenzene (manufactured by NARD INSTITUTE, LTD.) and 29.6 mg of 3, 6-diaminocarbazole were added, and these compounds were dissolved in 1480 mg of N,N-dimethylacetamide. This mixture was filtered through a filter having a pore size of 0.2 µm to prepare a composition (a coating composition).

### (2) Production of organic semiconductor layer

Using the composition obtained in the above step (1), an organic semiconductor layer (hereinafter, referred to as BTA-DAC) was obtained in the same manner as in Example 1.

### (3) Structure of organic semiconductor layer

### (3-1) Solubility in organic solvent

A BTA-DAC layer was produced in the same manner as in Example 1. The resulting layer was insoluble in N,N-dimethylacetamide and proved to have a three-dimensional network structure.

### (3-2) Band gap

The UV-Vis spectrum of the BTA-DAC layer was measured in the same manner as in Example 1 to determine a band gap from the absorption edge.

### (3-3) Measurements of HOMO and LUMO values

The oxidation-reduction potential (HOMO value) of the BTA-DAC layer measured in the same manner as in Example 1 was 5.7 eV. The band gap value was subtracted from the resulting value to calculate the LUMO value. The resulting LUMO value was 3.1 eV.

### (4) Evaluation of electric properties (diode properties)

Two pn-junction rectifiers, each composed of silicon and the BTA-DAC layer, were obtained in the same manner as in Example 1. The rectification was measured by applying a voltage on these rectifiers. The results provided clear rectification properties as shown in Fig. 10. Thus, the produced BTA-DAC layer proved to be an intrinsic semiconductor having both p-type and n-type properties.

### (5) Photoelectric conversion evaluation

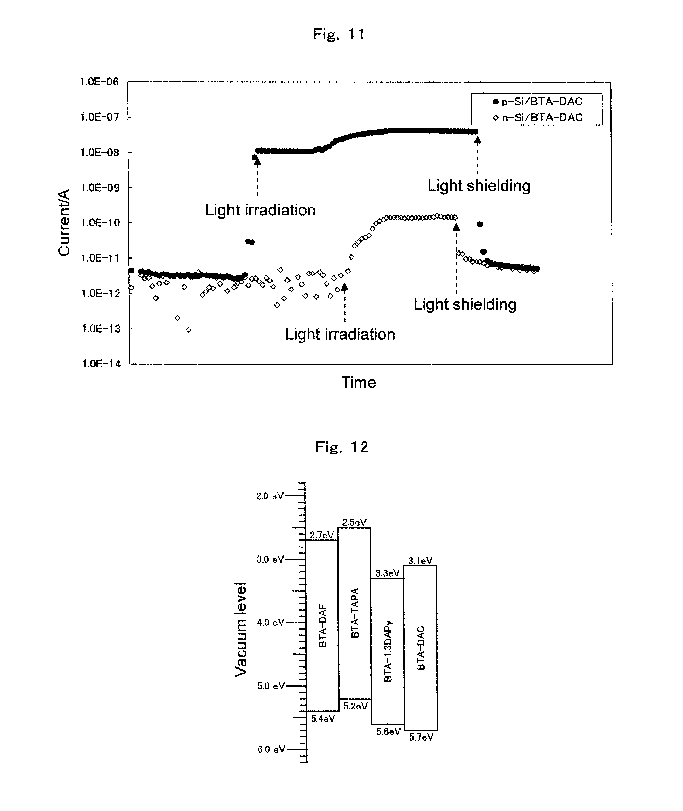

Two photoelectric conversion elements, each composed of silicon and the BTA-DAC layer, were produced in the same manner as in Example 1. The light response properties of these elements are shown in Fig. 11. The open-circuit voltage andtheshort-circuitcurrent measured were 0. 2 V and 100 µA/cm², respectively, in combination with the p-type silicon, and 0.08V and 0.1 µA/cm², respectively, in combination with the n-type silicon.

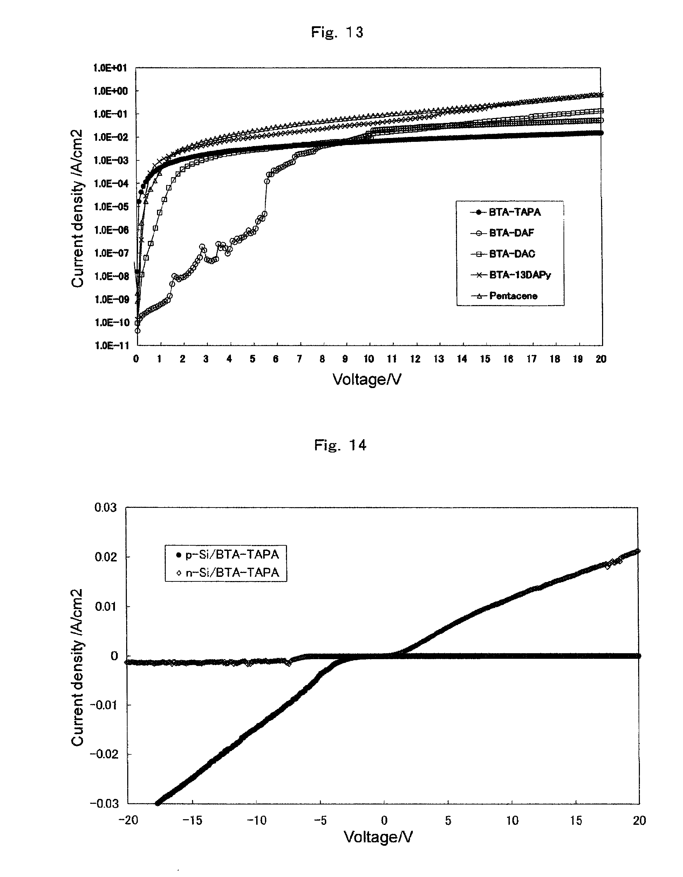

The HOMO and LUMO values in the organic semiconductors obtained in Examples 1 to 4 are summarized in Fig. 12. The conductive properties of these semiconductors are summarized in Fig . 13. Fig. 13 also shows the conductive properties of pentacene as a comparison. Figs. 12 and 13 proved that the adjustment of the molecular structure of the composition freely control the semiconductor properties.

### Example 5

### (1) Production of organic semiconductor

Each of 1,3,5-triformylbenzene (manufactured by NARD INSTITUTE, LTD.) and tris(4-aminophenyl)amine was vaporized by heating under a reduced pressure (carrier gas: nitrogen, pressure: 100 Pa, heating temperature of 1,3,5-triformylbenzene: 100°C, heating temperature of tris(4-aminophenyl)amine: 200°C), and these gases were mixed. Then the mixed gas was heated to 250°C at a flow rate of 5 sccm to react 1,3,5-triformylbenzene with tris(4-aminophenyl)amine to form a layer of the reaction product on a substrate. The resulting laminate was heat-treated at 300°C for 20 minutes under a nitrogen atmosphere to give a BTA-TAPA layer.

### (2) Structure of organic semiconductor layer

### (2-1) Solubility in organic solvent

A silicon wafer (or glass plate) was used as a substrate, and a BTA-TAPA layer was produced according to the method of the step (1). The resulting layer was insoluble in N,N-dimethylacetamide and proved to have a three-dimensional network structure.

### (2-2) Band gap

A glass plate was used as a substrate, and a BTA-TAPA layer was produced according to the method of the step (1). The band gap of the resulting layer was determined in the same manner as in Example 1 (3-2). As comparison, the band gap of 1,3,5-triformylbenzene and that of tris(4-aminophenyl)amine were determined. The results revealed that the band gap of the BTA-TAPA layer was smaller than those of the composition components. Thus the resulting BTA-TAPA layer proved to have a structure having a more extended π-conjugated system by the crosslinking reaction.

### (3) Evaluation of electric properties (diode properties)

Usingp-type andn-type silicon wafers as substrates, two pn-junction rectifiers, each composed of silicon and the BTA-TAPA layer, were obtained according to the method of the step (1) . The rectification was measured by applying a voltage on these rectifiers. The results provided clear rectification properties as shown in Fig. 14. Thus, the produced BTA-TAPA layer proved to be an intrinsic semiconductor having both p-type and n-type properties.

### (4) Organic EL device

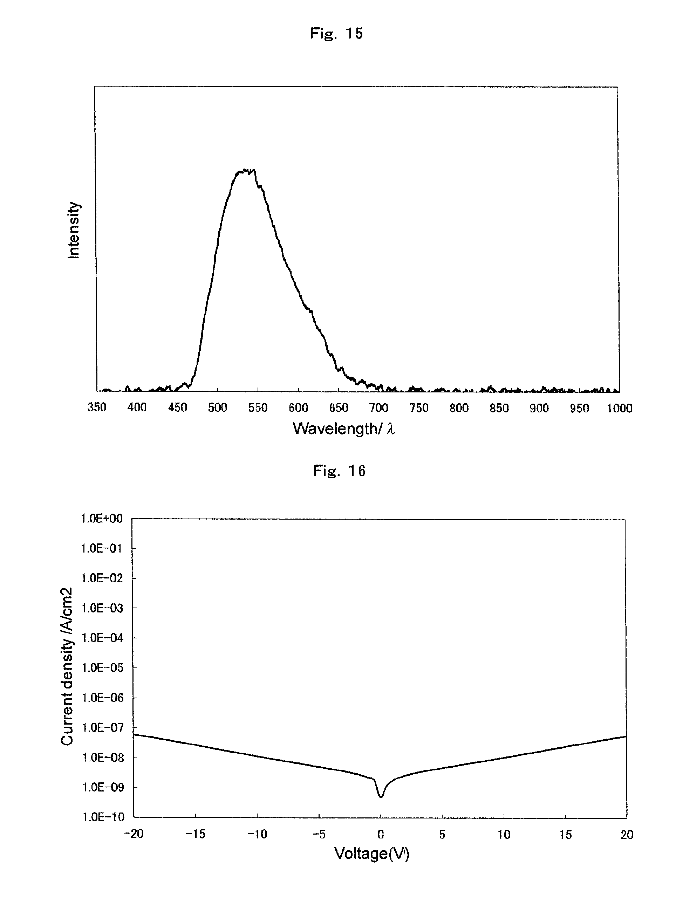

A glass plate having an ITO layer formed thereon was subjected to ultrasonic cleaning in acetone, and then the surface of the ITO was washed by ozone irradiation. According to the method of the step (1), a BTA-TAPA layer having a thickness of 30 nm was formed on the ITO layer. The resulting product was set in a vacuum evaporation apparatus (manufactured by ULVAC, Inc., "VPC-410"), and an Alq3 layer having a thickness of 30 nm was formed on the organic semiconductor layer by deposition. Further, a lithium-aluminum alloy (lithium content: 0.5% by weight) layer having a thickness of 300 nm was formed thereon by deposition to produce an organic EL device. The introduction of electric current to the organic EL device provided green luminescence derived from Alq3 as Fig. 15. This proved that the organic semiconductor layer functioned as a hole-transporting layer.

### Comparative Example 1

### (1) Preparation of composition (coating composition)

In a 30-ml eggplant flask, 55.3 mg of adamantanetrialdehyde (manufactured by NARD INSTITUTE, LTD.) and of 42.9 mg of 3, 3'-diaminobenzidine were added, and these compounds were dissolved in 884 mg of N,N-dimethylacetamide. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 300°C for 1 hour under a nitrogen atmosphere to give an organic semiconductor layer.

### (3) Structure of organic semiconductor layer (Solubility in organic solvent)

A silicon wafer (or glass plate) was used as a substrate, and an organic semiconductor layer was produced according to the method of the step (2). The resulting organic semiconductor layer was insoluble in N,N-dimethylacetamide and proved to have a three-dimensional network structure.

### (4) Evaluation of electric properties (diode properties)

Usingp-typeandn-type silicon wafers as substrates, a BTA-TAPA layer was formed on each substrate according to the method of the step (2). The electric properties of the resulting organic semiconductor layer measured in the same manner as in Example 1 (4) do not show electric current, as shown in Fig. 16, and thus the layer was an insulator layer.

### Example 6

### (1) Preparation of composition (coating composition)

In a 6-ml sample bottle, 8.1 mg of 1,3,5-triformylbenzene (manufactured by NARD INSTITUTE, LTD.), 37.3 mg of 2,2':5',2" terthiophene, and 0.5 mg of styrenesulfonic acid were added, and these compounds were dissolved in 900 mg of cyclohexanone. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 100°C for 30 minutes under a nitrogen atmosphere to give an organic semiconductor layer (hereinafter, referred to as BTA-3T).

### (3) Structure of organic semiconductor layer

### (3-1) Solubility in organic solvent

A silicon wafer (or glass plate) was used as a substrate, and a BTA-3T layer was produced according to the method of the step (2). The resulting layer was insoluble in cyclohexanone and proved to have a three-dimensional network structure.

### (3-2) Band gap

A glass plate was used as a substrate, and a BTA-3T layer was produced according to the method of the step (2). The UV-Vis spectrum of the BTA-3T layer was measured to determine a band gap from the absorption edge. As comparison, the band gap of 1,3,5-triformylbenzene and that of 2,2':5',2" -terthiophene were determined. The results revealed that the band gap of the BTA-3T layer was smaller than those of the composition components. Thus the resulting BTA-3T layer proved to have a structure having a more extended conjugated system by the crosslinking reaction.

### (3-3) Measurements of HOMO and LUMO values

According to the method of the step (2), a platinum plate was coated with a BTA-3T layer. Using the platinum plate as a working electrode, the oxidation-reduction potential (HOMO value) was measured by cyclic voltammetry (manufactured by BAS Inc., "AL600A"). The resulting oxidation-reduction potential (HOMO value) was 6.3 eV. The band gap value was subtracted from the resulting value to calculate the LUMO value. The resulting LUMO value was 3. 5 eV.

### (4) Evaluation of electric properties (diode properties)

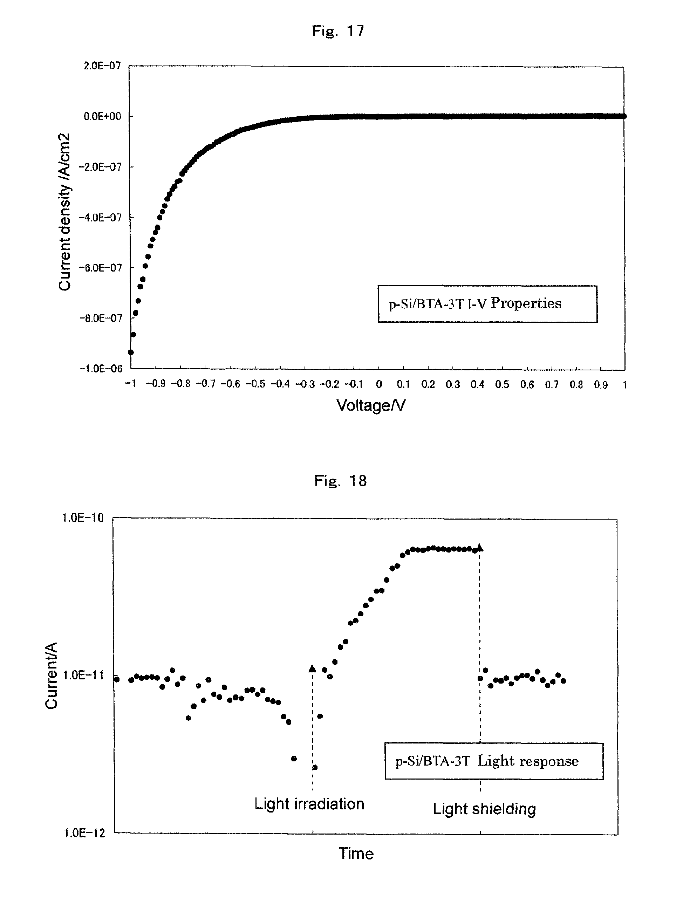

Using a p-type silicon wafer as a substrate, a BTA-3T layer was formed on the substrate according to the method of the step (2). Then an aluminum electrode having a diameter of 1 mm and a thickness of 700 nm was formed on the BTA-3T layer by vacuum evaporation to give a pn-j unction rectifier. The rectification was measured by applying a voltage on the rectifier. The results provided clear rectification properties as shown in Fig. 17. Thus, the produced BTA-3T layer proved to be an organic semiconductor.

### (5) Photoelectric conversion evaluation

Using a p-type silicon wafer as a substrate, a BTA-3T layer having a thickness of 50 nm was formed on the substrate according to the method of the step (2). An ITO layer was formed on the BTA-3T layer by sputtering to give a photoelectric conversion element. The light response properties of the element are shown in Fig. 18. The open-circuit voltage and the short-circuit current measured were 0.5 V and 0.47 µA/cm², respectively.

### Example 7

### (1) Preparation of composition (coating composition)

In a 6-ml sample bottle, 4.9 mg of 1,3,5-triformylbenzene (manufactured by NARD INSTITUTE, LTD.), 17.3 mg of trans-1,2-di(2-thienyl)ethylene, and 0.5 mg of styrenesulfonic acid were added, and these compounds were dissolved in 740 mg of cyclohexanone. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 100°C for 30 minutes under a nitrogen atmosphere to give an organic semiconductor layer (hereinafter, referred to as BTA-DTE).

### (3) Structure of organic semiconductor layer

### (3-1) Solubility in organic solvent

A silicon wafer (or glass plate) was used as a substrate, and a BTA-DTE layer was produced according to the method of the step (2). The resulting layer was insoluble in cyclohexanone and proved to have a three-dimensional network structure.

### (3-2) Band gap

A glass plate was used as a substrate, and a BTA-DTE layer was produced according to the method of the step (2) . The UV-Vis spectrum of the BTA-DTE layer was measured to determine a band gap from the absorption edge. As comparison, the band gap of 1,3,5-triformylbenzene and that of trans-1,2-di(2-thienyl)ethylene were determined. The results revealed that the band gap of the BTA-DTE layer was smaller than those of the composition components. Thus the resulting BTA-DTE layer proved to have a structure having a more extended conjugated system by the crosslinking reaction.

### (3-3) Measurements of HOMO and LUMO values

According to the method of the step (2), a platinum plate was coated with a BTA-DTE layer. Using the platinum plate as a working electrode, the oxidation-reduction potential (HOMO value) was measured by cyclic voltammetry (manufactured by BAS Inc., "AL600A"). The resulting oxidation-reduction potential (HOMO value) was 5.1eV. The band gap value was subtracted from the resulting value to calculate the LUMO value. The resulting LUMO value was 2. 3 eV.

### (4) Evaluation of electric properties (diode properties)

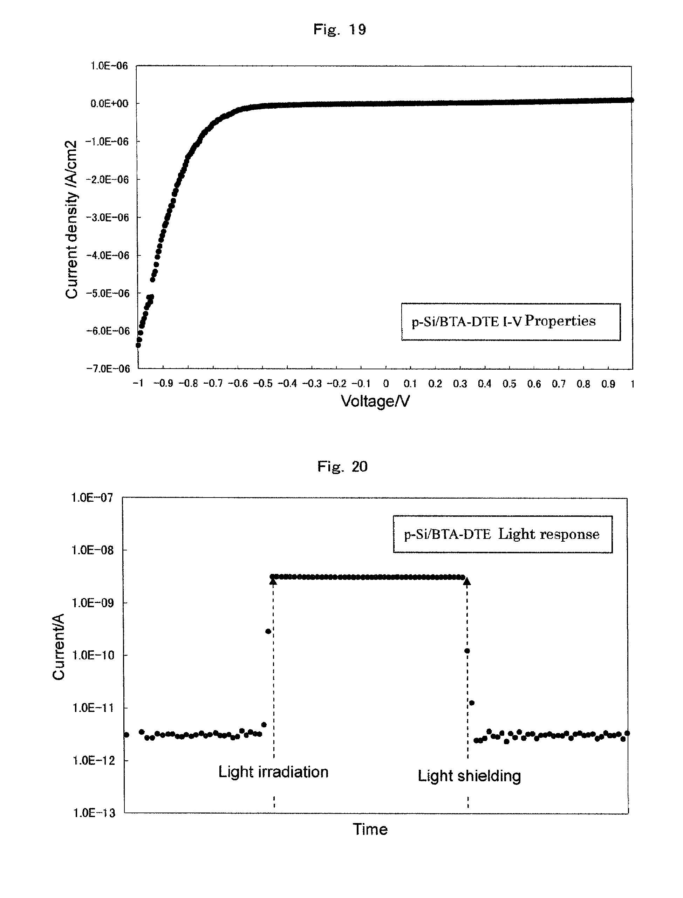

Using a p-type silicon wafer as a substrate, a BTA-DTE layer was formed on the substrate according to the method of the step (2). Then an aluminum electrode having a diameter of 1 mm and a thickness of 700 nm was formed on the BTA-DTE layer by vacuum evaporation to give a pn-junction rectifier. The rectification was measured by applying a voltage on the rectifier. The results provided clear rectification properties as shown in Fig. 19. Thus, the produced BTA-DTE layer proved to be an organic semiconductor.

### (5) Photoelectric conversion evaluation

Using a p-type silicon wafer as a substrate, a BTA-DTE layer having a thickness of 50 nm was formed on the substrate according to the method of the step (2). An ITO layer was formed on the BTA-DTE layer by sputtering to give a photoelectric conversion element. The light response properties of the element are shown in Fig. 20. The open-circuit voltage and the short-circuit current measured were 0.1 V and 0.38 µA/cm², respectively.

### Example 8

### (1) Preparation of composition (coating composition)

In a 6-ml sample bottle, 16.2 mg of 1,3,5-triformylbenzene (manufactured by NARD INSTITUTE, LTD.), 20.1 mg of pyrrole, and 0.5 mg of styrenesulfonic acid were added, and these compounds were dissolved in 1200 mg of cyclohexanone. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 100°C for 30 minutes under a nitrogen atmosphere to give an organic semiconductor layer (hereinafter, referred to as BTA-Py).

### (3) Structure of organic semiconductor layer

### (3-1) Solubility in organic solvent

A silicon wafer (or glass plate) was used as a substrate, and a BTA-Py layer was produced according to the method of the step (2). The resulting layer was insoluble in cyclohexanone and proved to have a three-dimensional network structure.

### (3-2) Band gap

A glass plate was used as a substrate, and a BTA-Py layer was produced according to the method of the step (2) . The UV-Vis spectrum of the BTA-Py layer was measured to determine a band gap from the absorption edge. As comparison, the band gap of 1, 3, 5-triformylbenzene and that of pyrrole were determined. The results revealed that the band gap of the BTA-Py layer was smaller than those of the composition components. Thus the resulting BTA-Py layer proved to have a structure having a more extended conjugated system by the crosslinking reaction.

### (3-3) Measurements of HOMO and LUMO values

According to the method of the step (2), a platinum plate was coated with a BTA-Py layer. Using the platinum plate as a working electrode, the oxidation-reduction potential (HOMO value) was measured by cyclic voltammetry (manufactured by BAS Inc., "AL600A"). The resulting oxidation-reduction potential (HOMO value) was 5.4 eV. The band gap value was subtracted from the resulting value to calculate the LUMO value. The resulting LUMO value was 3.5 eV.

### (4) Evaluation of electric properties (diode properties)

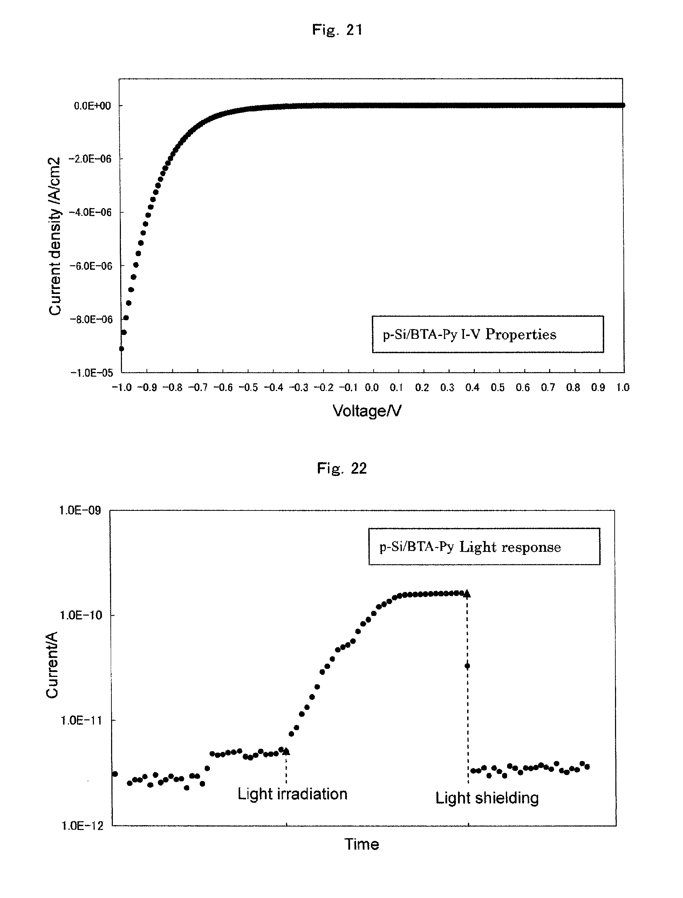

Using a p-type silicon wafer as a substrate, a BTA-Py layer was formed on the substrate according to the method of the step (2). Then an aluminum electrode having a diameter of 1 mm and a thickness of 700 nm was formed on the BTA-Py layer by vacuum evaporation to give a pn-junction rectifier. The rectification was measured by applying a voltage on the rectifier. The results provided clear rectification properties as shown in Fig. 21. Thus, the produced BTA-Py layer proved to be an organic semiconductor.

### (5) Photoelectric conversion evaluation

Using a p-type silicon wafer as a substrate, a BTA-Py layer having a thickness of 50 nm was formed on the substrate according to the method of the step (2) . An ITO layer was formed on the BTA-Py layer by sputtering to give a photoelectric conversion element. The light response properties of the element are shown in Fig. 22. The open-circuit voltage and the short-circuit current measured were 0.45 V and 1.3 µA/cm², respectively.

### Example 9

### (1) Preparation of composition (coating composition)

In a 6-ml sample bottle, 8.1 mg of 1,3,5-triformylbenzene (manufactured by NARD INSTITUTE, LTD.) and 9.6 mg of 3-thiopheneboronic acid were added, and these compounds were dissolved in 740 mg of cyclohexanone. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 100°C for 1 hour under a nitrogen atmosphere to give an organic semiconductor layer (hereinafter, referred to as BTA-TbA).

### (3) Structure of organic semiconductor layer

### (3-1) Solubility in organic solvent

A silicon wafer (or glass plate) was used as a substrate, and a BTA-TbA layer was produced according to the method of the step (2). The resulting layer was insoluble in cyclohexanone and proved to have a three-dimensional network structure.

### (3-2) Band gap

A glass plate was used as a substrate, and a BTA-TbA layer was produced according to the method of the step (2). The UV-Vis spectrum of the BTA-TbA layer was measured to determine a band gap from the absorption edge. As comparison, the band gap of 1,3,5-triformylbenzene and that of 3-thiopheneboronic acid were determined. The results revealed that the band gap of the BTA-TbA layer was smaller than those of the composition components. Thus the resulting BTA-TbA layer proved to have a structure having a more extended conjugated system by the crosslinking reaction.

### (3-3) Measurements of HOMO and LUMO values

According to the method of the step (2), a platinum plate was coated with a BTA-TbA layer. Using the platinum plate as a working electrode, the oxidation-reduction potential (HOMO value) was measured by cyclic voltammetry (manufactured by BAS Inc., "AL600A"). The resulting oxidation-reduction potential (HOMO value) was 5.4eV. The band gap value was subtracted from the resulting value to calculate the LUMO value. The resulting LUMO value was 2. 6 eV.

### (4) Evaluation of electric properties (diode properties)

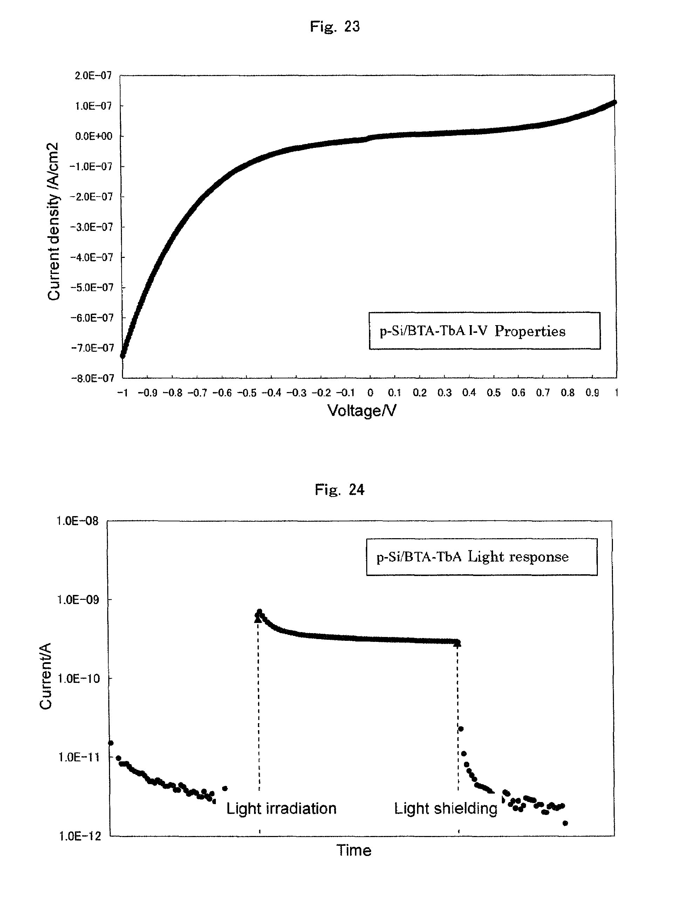

Using a p-type silicon wafer as a substrate, a BTA-TbA layer was formed on the substrate according to the method of the step (2). Then an aluminum electrode having a diameter of 1 mm and a thickness of 700 nm was formed on the BTA-TbA layer by vacuum evaporation to give a pn-junction rectifier. The rectification was measured by applying a voltage on the rectifier. The results provided clear rectification properties as shown in Fig. 23. Thus, the produced BTA-TbA layer proved to be an organic semiconductor.

### (5) Photoelectric conversion evaluation

Using a p-type silicon wafer as a substrate, a BTA-TbA layer having a thickness of 50 nm was formed on the substrate according to the method of the step (2). An ITO layer was formed on the BTA-TbA layer by sputtering to give a photoelectric conversion element. The light response properties of the element are shown in Fig. 24. The open-circuit voltage and the short-circuit current measured were 0.6 V and 0.51 µA/cm², respectively.

### Example 10

### (1) Preparation of composition (coating composition)

In a 6-ml sample bottle, 8.1 mg of 1,3,5-triformylbenzene (manufactured by NARD INSTITUTE, LTD.), 21.0 mg of ethyl 3-furancarboxylate, and 0.5 mg of styrenesulfonic acid were added, and these compounds were dissolved in 970 mg of cyclohexanone. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 100°C for 1 hour under a nitrogen atmosphere to give an organic semiconductor layer (hereinafter, referred to as BTA-FCE).

### (3) Structure of organic semiconductor layer

### (3-1) Solubility in organic solvent

A silicon wafer (or glass plate) was used as a substrate, and a BTA-FCE layer was produced according to the method of the step (2). The resulting layer was insoluble in cyclohexanone and proved to have a three-dimensional network structure.

### (3-2) Band gap

A glass plate was used as a substrate, and a BTA-FCE layer was produced according to the method of the step (2) . The UV-Vis spectrum of the BTA-FCE layer was measured to determine a band gap from the absorption edge . As comparison, the band gap of 1,3,5-triformylbenzene and that of ethyl 3-furancarboxylate were determined. The results revealed that the band gap of the BTA-FCE layer was smaller than those of the composition components. Thus the resulting BTA-FCE layer proved to have a structure having a more extended conjugated system by the crosslinking reaction.

### (3-3) Measurements of HOMO and LUMO values

According to the method of the step (2), a platinum plate was coated with a BTA-FCE layer. Using the platinum plate as a working electrode, the oxidation-reduction potential (HOMO value) was measured by cyclic voltammetry (manufactured by BAS Inc., "AL600A"). The resulting oxidation-reduction potential (HOMO value) was5.3eV. The band gap value was subtracted from the resulting value to calculate the LUMO value. The resulting LUMO value was 2. 6 eV.

### (4) Evaluation of electric properties (diode properties)

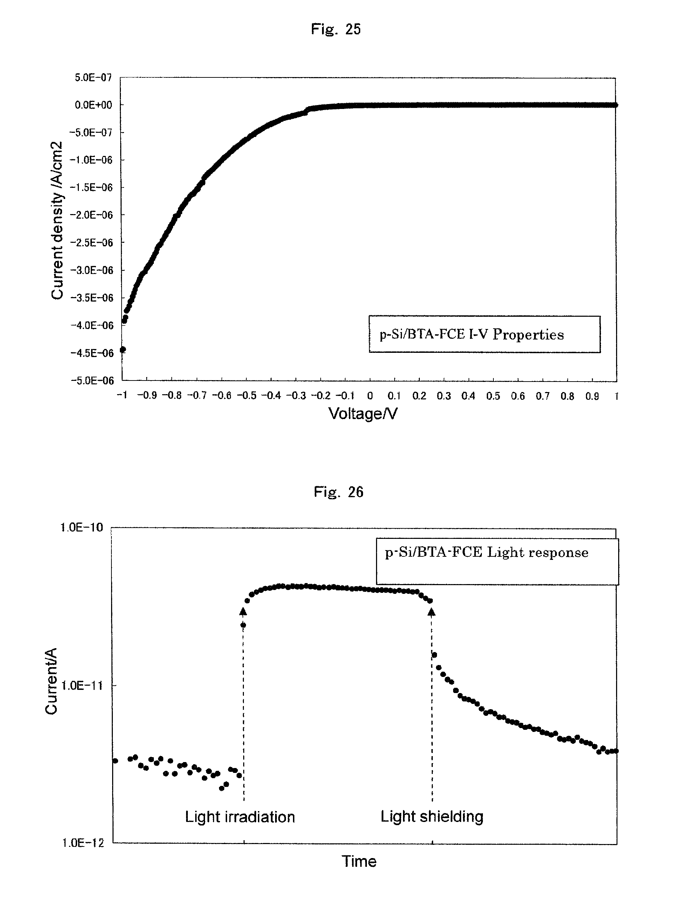

Using a p-type silicon wafer as a substrate, a BTA-FCE layer was formed on the substrate according to the method of the step (2). Then an aluminum electrode having a diameter of 1 mm and a thickness of 700 nm was formed on the BTA-FCE layer by vacuum evaporation to give a pn-junction rectifier. The rectification was measured by applying a voltage on the rectifier. The results provided clear rectification properties as shown in Fig. 25. Thus, the produced BTA-FCE layer proved to be an organic semiconductor.

### (5) Photoelectric conversion evaluation

Using a p-type silicon wafer as a substrate, a BTA-FCE layer having a thickness of 50 nm was formed on the substrate according to the method of the step (2). An ITO layer was formed on the BTA-FCE layer by sputtering to give a photoelectric conversion element. The light response properties of the element are shown in Fig. 26. The open-circuit voltage and the short-circuit current measured were 0.56 V and 0.54 µA/cm², respectively.

### Example 11

### (1) Preparation of composition (coating composition)

In a 6-ml sample bottle, 2.0 mg of 1,3,5-triformylbenzene (manufactured by NARD INSTITUTE, LTD.), 10.0 mg of poly(3-hexylthiophene) (manufactured by Sigma-Aldrich: molecular weight 15,000 to 45, 000), and 0.5 mg of styrenesulfonic acid were added, and these compounds were dissolved in 600 mg of dichlorobenzene. This mixture was filtered through a filter having a pore size of 0.45 µm to prepare a composition (a coating composition).

### (2) Production of organic semiconductor layer

The composition obtained in the step (1) was applied to a substrate by spin coating to produce a thin layer and then subjected to heat treatment at 150°C for 1 hour under a nitrogen atmosphere to give an organic semiconductor layer (hereinafter, referred to as BTA-P3HT).

### (3) Structure of organic semiconductor layer

### (3-1) Solubility in organic solvent

A silicon wafer (or glass plate) was used as a substrate, and a BTA-P3HT layer was produced according to the method of the step (2). The resulting layer was insoluble in cyclohexanone and proved to have a three-dimensional network structure.

### Example 12

### (1) Preparation of composition (coating composition)

In a 6-ml sample bottle, 16.5 mg of tris(4-formylphenyl)amine and 16.5 mg of 2,2`-bis(trifluoromethyl)benzidine were added, and these compounds were dissolved in 1350 mg of cyclohexanone. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 300°C for 1 hour under a nitrogen atmosphere to give an organic semiconductor layer (hereinafter, referred to as TFPA-BFME).

### (3) Structure of organic semiconductor layer

### (3-1) Solubility in organic solvent

A silicon wafer (or glass plate) was used as a substrate, and a TFPA-BFME layer was produced according to the method of the step (2). The resulting layer was insoluble in cyclohexanone and proved to have a three-dimensional network structure.

### (3-2) Band gap

A glass plate was used as a substrate, and a TFPA-BFME layer was produced according to the method of the step (2). The UV-Vis spectrum of the TFPA-BFME layer was measured to determine a band gap from the absorption edge. As comparison, the band gap of tris(4-formylphenyl)amine and that of 2,2'-bis(trifluoromethyl)benzidine were determined. The results revealed that the band gap of the TFPA-BFME layer was smaller than those of the composition components. Thus the resulting TFPA-BFME layer proved to have a structure having a more extended conjugated system by the crosslinking reaction.

### (3-3) Measurements of HOMO and LUMO values

According to the method of the step (2), a platinum plate was coated with a TFPA-BFME layer. Using the platinum plate as a working electrode, the oxidation-reduction potential (HOMO value) was measured by cyclic voltammetry (manufactured by BAS Inc., "AL600A"). The resulting oxidation-reduction potential (HOMO value) was6.5eV. The band gap value was subtracted from the resulting value to calculate the LUMO value. The resulting LUMO value was 3.8 eV.

### (4) Evaluation of electric properties (diode properties)

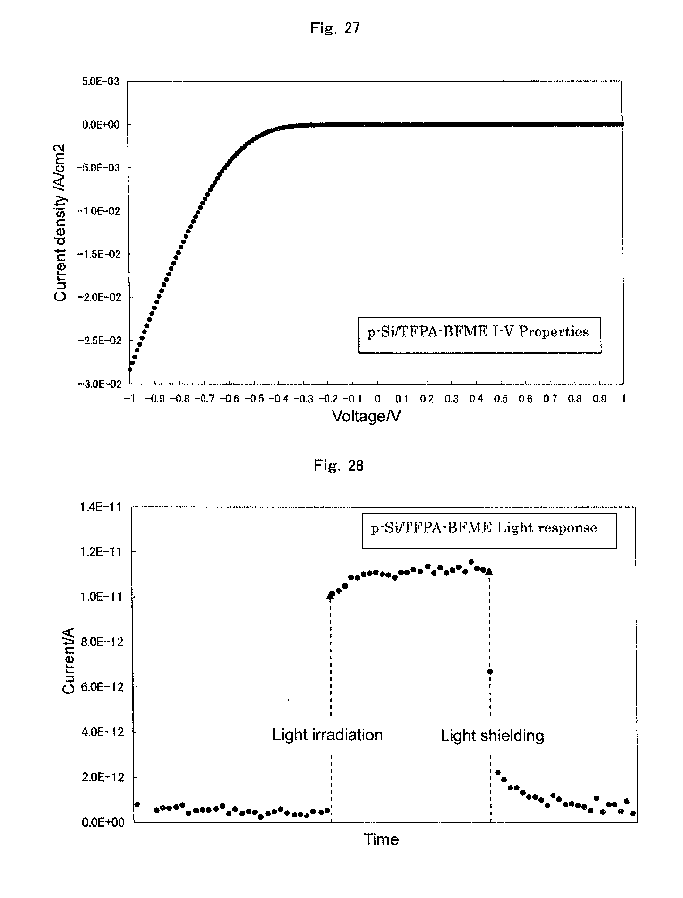

Using a p-type silicon wafer as a substrate, a TFPA-BFME layer was formed on the substrate according to the method of the step (2). Then an aluminum electrode having a diameter of 1 mm and a thickness of 700 nm was formed on the TFPA-BFME layer by vacuum evaporation to give a pn-junction rectifier. The rectification was measured by applying a voltage on the rectifier. The results provided clear rectification properties as shown in Fig. 27. Thus, the produced TFPA-BFME layer proved to be an organic semiconductor.

### (5) Photoelectric conversion evaluation

Using a p-type silicon wafer as a substrate, a TFPA-BFME layer having a thickness of 50 nm was formed on the substrate according to the method of the step (2). An ITO layer was formed on the TFPA-BFME layer by sputtering to give a photoelectric conversion element. The light response properties of the element are shown in Fig. 28. The open-circuit voltage and the short-circuit current measured were 0.15 V and 0.04 µA/cm², respectively.

### Example 13

### (1) Preparation of composition (coating composition)

In a 6-m1 sample bottle, 4.0 mg of terephthalaldehyde, 60.4 mg of a thiophene compound having a fullerene unit ([6,6]-phenyl-C61-butyric acid (3-ethylthiophene) ester), and 0.5 mg of styrenesulfonic acid were added, and these compounds were dissolved in 3500 mg of cyclohexanone. This mixture was filtered through a filter having a pore size of 0.2 µm to prepare a composition (a coating composition).

### (2) Production of organic semiconductor layer

The composition obtained in the step (1) was applied to a substrate by spin coating to produce a thin layer and then subjected to heat treatment at 100°C for 1 hour under a nitrogen atmosphere to give an organic semiconductor layer (hereinafter, referred to as TFA-PCBT).

### (3) Structure of organic semiconductor layer

### (3-1) Solubility in organic solvent

A silicon wafer (or glass plate) was used as a substrate, and a TFA-PCBT layer was produced according to the method of the step (2). The resulting layer was insoluble in cyclohexanone and proved to have a three-dimensional network structure.

### (3-2) Band gap

A glass plate was used as a substrate, and a TFA-PCBT layer was produced according to the method of the step (2). The UV-Vis spectrum of the TFA-PCBT layer was measured to determine a band gap from the absorption edge . As comparison, the band gap of terephthalaldehyde and that of [6,6]-phenyl-C61-butyric acid (3-ethylthiophene) ester were determined. The results revealed that the band gap of the TFA-PCBT layer was smaller than those of the composition components. Thus the resulting TFA-PCBT layer proved to have a structure having a more extended conjugated system by the crosslinking reaction.

### (3-3) Measurements of HOMO and LUMO values

According to the method of the step (2), a platinum plate was coated with a TFA-PCBT layer. Using the platinum plate as a working electrode, the oxidation-reduction potential (HOMO value) was measured by cyclic voltammetry (manufactured by BAS Inc., "AL600A"). The resulting oxidation-reduction potential (HOMO value) was5.7eV. The band gap value was subtracted from the resulting value to calculate the LUMO value. The resulting LUMO value was 3.5 eV.

### (4) Evaluation of electric properties (diode properties)

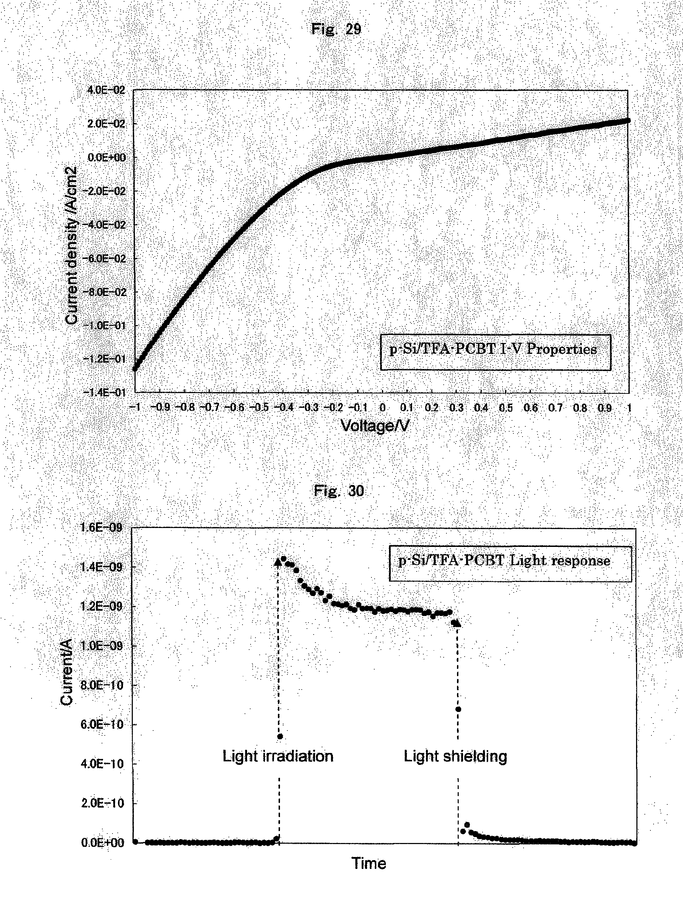

Using a p-type silicon wafer as a substrate, a TFA-PCBT layer was formed on the substrate according to the method of the step (2). Then an aluminum electrode having a diameter of 1 mm and a thickness of 700 nm was formed on the TFA-PCBT layer by vacuum evaporation to give a pn-junction rectifier. The rectification was measured by applying a voltage on the rectifier. The results provided clear rectification properties as shown in Fig. 29. Thus, the produced TFA-PCBT layer proved to be an organic semiconductor.

### (5) Photoelectric conversion evaluation

Using a p-type silicon wafer as a substrate, a TFA-PCBT layer having a thickness of 50 nm was formed on the substrate according to the method of the step (2). An ITO layer was formed on the TFA-PCBT layer by sputtering to give a photoelectric conversion element. The light response properties of the element are shown in Fig. 30. The open-circuit voltage and the short-circuit current measured were 0.55 V and 0.15 µA/cm², respectively.

### INDUSTRIAL APPLICABILITY

The composition of the present invention is useful for forming an organic semiconductor (a high-molecular-weight type organic semiconductor) having a low resistance and a high conductivity. Thus, the organic semiconductor formed with the composition is usable for various devices. These devices includes a rectifier (a diode), a transistor [such as a junction transistor (a bipolar transistor) or a field effect transistor (a unipolar transistor)], a photoelectric conversion element (such as a solar cell device or an organic EL device), and other devices.

## Claims

1. A crosslinkable composition comprising:
an aromatic polycarbonyl compound having a carbonyl group as a reactive site, and
at least one aromatic reactive component selected from the group consisting of an aromatic polyamine having an amino group as a reactive site, and an aromatic heterocyclic compound having a plurality of unmodified α-carbon positions, as reactive sites, each of which is adjacent to a hetero atom of a heterocycle thereof,
provided that when the aromatic reactive component is the aromatic heterocyclic compound, the aromatic polycarbonyl compound is an aromatic polyaldehyde compound;
wherein at least one component of the aromatic polycarbonyl compound and the aromatic reactive component has not less than 3 reactive sites in one molecule thereof.

2. A composition according to claim 1, wherein the aromatic polycarbonyl compound is represented by the following formula (Ia): 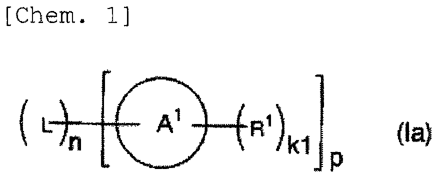 wherein L represents a linker; A¹ represents an aromatic ring; R¹ represents a carbonyl-containing group; n is 0 or 1; k1 is an integer of not less than 1; and p is an integer of not less than 1; with the proviso that k1 x p is an integer of not less than 2.

3. A composition according to claim 2, wherein the aromatic polycarbonyl compound represented by the formula (Ia) is one of the followings:
(a1) a compound, wherein the ring A¹ is a monocyclic or condensed bi- to heptacyclic aromatic hydrocarbon ring, or a condensed bi- to heptacyclic nitrogen-atom-containing aromatic heterocycle; n is 0; k1 is 2 or 3; and p is 1;
(a2) a compound, wherein the ring A¹ is a monocyclic or condensed bi- to heptacyclic aromatic hydrocarbon ring; n is 0; k1 is 1 or 2; and p is 2;
(a3) a compound, wherein the ring A¹ is a monocyclic or condensed bi- to heptacyclic aromatic hydrocarbon ring; the linker L is nitrogen atom, oxygen atom, sulfur atom, vinylene group, a di- to tetravalent aromatic carbocyclic or aromatic heterocyclic group; n is 1; k1 is 1 or 2; and p is 2 to 4; and
(a4) a compound, wherein the ring A¹ is a porphyrin or phthalocyanine ring; n is 0; k1 is 2 to 4; and p is 1.

4. A composition according to any one of claims 1 to 3, wherein the aromatic polyamine is a compound represented by the following formula (IIa): 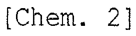 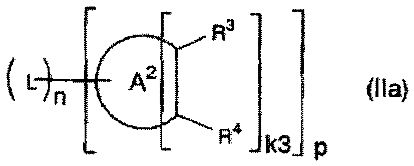 wherein A² represents an aromatic ring; R³ represents an amino group; R⁴ represents hydrogen atom, an amino group, a mercapto group, or hydroxyl group; k3 is an integer of not less than 1; and L, n, and p have the same meanings as defined above; with the proviso that k3 x p is an integer of not less than 2.

5. A composition according to claim 4, wherein the aromatic polyamine represented by the formula (IIa) is one of the followings:
(b1) a compound, wherein the ring A² is a monocyclic or condensed bi- to heptacyclic aromatic hydrocarbon ring, or a condensed bi- to heptacyclic nitrogen-atom-containing aromatic heterocycle; n is 0; k3 is 2 or 3; and p is 1,
(b2) a compound, wherein the ring A² is a monocyclic or condensed bi- to heptacyclic aromatic hydrocarbon ring; n is 0; k3 is 1 or 2; and p is 2,
(b3) a compound, wherein
the ring A² is a monocyclic or condensed bi- to heptacyclic aromatic hydrocarbon ring;
the linker L is nitrogen atom, oxygen atom, sulfur atom, disulfide group, vinylene group, a di- to tetravalent aromatic carbocyclic or aromatic heterocyclic group, a group which has an arylene group having an azo group at each terminal thereof, a group which has vinylene group having an azo group through an arylene group at each terminal thereof, or a group which has an arylarene-diyl group having an oxygen atom at each terminal thereof;
n is 1;
k3 is 1 or 2; and
p is 2 to 4, and
(b4) a compound, wherein the ring A² is a porphyrin or phthalocyanine ring; n is 0; k3 is 2 to 4; and p is 1.

6. A composition according to any one of claims 1 to 5, wherein the aromatic polycarbonyl compound comprises an aromatic polyaldehyde compound having 2 to 4 formyl groups as reactive sites in one molecule thereof; the aromatic reactive component comprises an aromatic polyamine having 2 to 4 amino groups as reactive sites in one molecule thereof; and at least one component of the aromatic polyaldehyde compound and the aromatic polyamine has not less than 3 reactive sites.

7. A composition according to any one of claims 1 to 6, wherein the aromatic heterocyclic compound comprises at least one member selected from the group consisting of a monocyclic compound, a condensed cyclic compound, and a ring-assembly compound, and
contains a 5- to 8-membered aromatic heterocycle having at least one hetero atom selected from the group consisting of oxygen atom, sulfur atom, nitrogen atom, selenium atom, and tellurium atom as a hetero atom of the heterocycle thereof.

8. A composition according to any one of claims 1 to 7, wherein the aromatic heterocyclic compound is represented by the following formula (III): 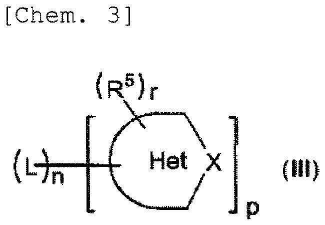 wherein the ring Het represents an aromatic heterocycle; X represents a hetero atom; R⁵ represents a non-reactive group; r is an integer of 0 to 3; and L, n, and p have the same meanings as defined above.

9. A composition according to any one of claims 1 to 8, wherein the aromatic heterocyclic compound contains a 5-membered aromatic heterocycle having at least one hetero atom selected from the group consisting of sulfur atom, oxygen atom, and nitrogen atom as a hetero atom of the heterocycle thereof.

10. A composition according to any one of claims 1 to 9, wherein the aromatic polycarbonyl compound comprises an aromatic polyaldehyde compound having 2 to 4 formyl groups as reactive sites in one molecule thereof; the aromatic reactive component comprises an aromatic heterocyclic compound having 2 to 8 unmodified α-carbon positions, as reactive sites in one molecule thereof, which are adjacent to a hetero atom of the heterocycle thereof; and at least one component of the aromatic polyaldehyde compound and the aromatic heterocyclic compound has not less than 3 reactive sites.

11. A composition according to any one of claims 1 to 10, wherein the ratio of the aromatic polycarbonyl compound relative to the aromatic reactive component is 70/30 to 30/70 as a ratio of the former/the latter in terms of an equivalent ratio of the reactive site.

12. A composition according to any one of claims 1 to 11, which further comprises an acid catalyst in an amount of 0.001 to 1 parts by weight relative to 1 part by weight of the total amount of the aromatic polyaldehyde compound and the aromatic heterocyclic compound.

13. A composition according to any one of claims 1 to 12, which further comprises an organic solvent in an amount of 0.1 to 200 parts by weight relative to 1 part by weight of the total amount of the aromatic polycarbonyl compound and the aromatic reactive component.

14. An organic semiconductor obtainable by heat-treating a composition recited in any one of claims 1 to 13.

15. An organic semiconductor according to claim 14, having a three-dimensional network structure substantially composed of a π-conjugated system as a whole.

16. An organic semiconductor according to claim 14 or 15, having a structure in which a unit derived from the aromatic polycarbonyl compound is coupled with a unit derived from the aromatic reactive component through at least one unit selected from the group consisting of a carbon-nitrogen double bond, an imidazole ring, an oxazole ring, a thiazole ring, a carbon-carbon single bond, and a carbon-carbon double bond.

17. An organic semiconductor according to any one of claims 14 to 16, which is insoluble or sparingly soluble in an organic solvent.

18. An organic-inorganic hybrid semiconductor, comprising:
an inorganic semiconductor and
an organic semiconductor recited in any one of claims 14 to 17 formed on at least one side of the inorganic semiconductor.

19. An organic-inorganic hybrid semiconductor according to claim 18, wherein the inorganic semiconductor comprises at least one metal selected from the group consistingofthegroup2B, 3B, and 4B elements of the Periodic Table, or an oxide thereof.

20. A process for producing an organic-inorganic hybrid semiconductor recited in claim 18 or 19, which comprises applying a composition recited in any one of claims 1 to 13 to at least one side of an inorganic semiconductor, and heat-treating the coated layer to form an organic semiconductor.

21. An electronic device comprising a semiconductor recited in any one of claims 14 to 19.
